# EUROPÄISCHE PATENTSCHRIFT

(11) **EP 3 414 356 B1**
(45) Veröffentlichungstag und Bekanntmachung des Hinweises auf die Patenterteilung: **21.04.2021**
(21) Anmeldenummer: 17705568.8
(22) Anmeldetag: 09.02.2017
(51) Int. Cl.: C23C 14/08, C23C 14/32, F02F 5/00, F16J 9/26, F16J 10/04, F02B 23/06

(54) **TRIBOLOGISCHES SYSTEM EINES VERBRENNUNGSMOTORS MIT BESCHICHTUNG**
TRIBOLOGICAL SYSTEM OF AN INTERNAL COMBUSTION ENGINE WITH A COATING
SYSTÈME TRIBOLOGIQUE D'UN MOTEUR À COMBUSTION INTERNE POURVU D'UN REVÊTEMENT

(30) Priorität: 12.02.2016 US 201662294488 P
(43) Veröffentlichungstag der Anmeldung: 19.12.2018
(73) Patentinhaber: Oerlikon Surface Solutions AG, Pfäffikon, 8808 Pfäffikon (CH)
(72) Erfinder: ERNST, Peter, 8174 Stadel b. Niederglatt (CH); RAMM, Jürgen, 7304 Maienfeld (CH); SEIBERT, Florian, 70771 Leinfelden-Echterdingen (DE); WIDRIG, Beno, 7310 Bad Ragaz (CH)
(74) Vertreter: MFG Patentanwälte Meyer-Wildhagen Meggle-Freund Gerhard PartG mbB
(86) Internationale Anmeldenummer: PCT/EP2017/052887
(87) Internationale Veröffentlichungsnummer: WO 2017/137500

(56) Entgegenhaltungen:
- WO-A1-2008/043606
- JP-A- S62 280 339
- JP-A- 2006 328 463

## Beschreibung

### TECHNISCHES GEBIET

Die vorliegende Offenbarung bezieht sich allgemein und insbesondere auf ein tribologisches System mit einem ersten Körper und einem zweiten Körper, die jeweils eine Komponente eines Verbrennungsmotors bilden, insbesondere Kolben, Kolbenring oder Zylinder, und deren Oberflächen einen ersten und zweiten Stoffbereich aufweisen, die jeweils als Schichten ausgebildet sind und sich im Betrieb wenigstens bereichsweise berühren und einen tribologischen Kontakt bilden.

Die Offenbarung bezieht sich sowohl auf die Schichtmaterialien die zur Herstellung der Schichten verwendet werden, wie auch auf die Verfahren, mit denen diese Schichten auf den entsprechenden Motorkomponenten aufgebracht werden. Sie bezieht sich auch auf die entsprechend beschichteten Motorkomponenten.

Im Weiteren bezieht sich die Offenbarung besonders auf die Auswahl bei der Kombination der Schichtmaterialien, mit denen die tribologischen Partner im tribologischen System beschichtet werden.

### TECHNISCHER HINTERGRUND

Die Bezeichnung Verbrennungsmotor soll hier alle Verbrennungskraftmaschinen umfassen, insbesondere Hubkolbenmotoren, die mit fossilen Brennstoffen wie Otto-, Diesel- oder Gaskraftstoffen (CNG, LNG) betrieben werden können.

Die Erhöhung der Betriebstemperaturen in Verbrennungsmotoren mit dem Ziel einer besseren Ausnutzung des Brennstoffs und die Verwendung von Zusätzen wie beispielsweise in Biokraftstoffen, stellen erhöhte Anforderungen an die thermische und chemische Stabilität von Oberflächen in Benzin-, Diesel- und Gasverbrennungsmotoren. Diesen erhöhten Anforderungen kann man nur bedingt oder nur mit grossen Kosten durch eine Auswahl der kompakten Materialien (auch Kompaktmaterialien genannt) für die Motorkomponenten gerecht werden.

Die Begriffe kompakte Materialien oder Kompaktmaterialien (bulk materials) bezeichnen die Materialien der Substrate, die beschichtet werden sollen, damit deren Eigenschaften an deren Oberfläche verbessert werden. Sie umfassen alle Materialien, die beschichtet werden können: z.B. Stahl, Al, Inconel, etc, also Materialien und Werkstoffe, aus denen man die Komponenten eines Verbrennungsmotors herstellt. Unter den Stählen ist z.B. 42CrMo4 ein typischer Werkstoff, aus dem Kolben gefertigt werden.

Eine Methode zur kostengünstigen Verbesserung der Eigenschaften der Kompaktmaterialien ist deren Oberflächenbehandlung, die beispielsweise durch Nitrierverfahren, Physikalische Gasphasenabscheidung (PVD) oder durch das Aufspritzen von Beschichtungen aus Pulvern oder Drähten mittels thermischer Spritzverfahren erfolgt (HVOF oder Plasma). Mit diesen Verfahren lassen sich Materialien herstellen, die nicht oder nur mit grossem Aufwand als kompakte Materialien hergestellt werden können, aber durch die, auch wenn die Modifikation nur einen relativ dünnen Bereich der Oberfläche betrifft, der Verschleiss, die Reibung und die Korrosion der Kompaktmaterialoberflächen drastisch beeinflusst werden können.

Im Normalfall bestehen die Oberflächen der tribologischen Partner in einem Verbrennungsmotor aus unterschiedlichen Materialien oder unterschiedlichen kompakten Materialien, wobei diese auf eine bestimmte Lebensdauer optimiert werden, um die Anzahl von Servicezyklen zu verringern, d.h. es erfolgt eine Lebensdaueranpassung. Meist werden in solchen Fällen Material oder Schichtdicke angepasst.

Neben dem Wunsch, den Verschleiss zu reduzieren, ist die Reduktion der Reibungsverluste ein weiteres Ziel bei der Entwicklung von Verbrennungsmotoren. Auch unter diesem Aspekt spielt die gezielte Veränderung der Oberfläche im tribologischen System eine wichtige Rolle. Neben den mechanischen Eigenschaften der Oberflächen und deren Anpassung untereinander, müssen die Oberflächenmaterialien auch noch so wichtige Funktionen wie die Benetzbarkeit mit den Ölen und eine gewisse Steuerung der chemischen Reaktionen von Additiven und Oberfläche übernehmen, ohne dabei selbst chemisch instabil zu werden. All diese Sachverhalte zeigen auf, dass die Optimierung des tribologischen Systems eines Verbrennungsmotors äußerst komplex ist und Flexibilität in der Auswahl und Abstimmung der Oberflächen aufeinander voraussetzt. Dünne Schichten bieten auch hier einen höheren Grad an Flexibilität als dies bei Kompaktmaterialien der Fall ist.

In EP 1 022 351 B1 wird die Beschichtung des Inneren eines Zylinders, der Zylinderlauffläche, beschrieben, wobei die Schicht mittels des Plasmaspritzverfahrens aufgebracht wird. Die grösstenteils eisenhaltige Schicht enthält auch Anteile an FeO und Fe2O3, wobei der Anteil des gebundenen Sauerstoffs zwischen 1 und 4 Gew.-% liegt und der Anteil an Fe2O3 unter 0.2 Gew.-% liegt. Als besonders vorteilhaft wird die Beimengung von oxydkeramischen Pulvern mit einem Anteil von 5 bis 50 Gew.-% zum Prozessgas empfohlen, damit noch bessere Reibungskoeffizienten erreicht werden. Als oxydkeramische Pulver werden TiO2, Al203-TiO2 und Al2O3-ZrO2 angegeben.

In EP 1 340 834 A2 wird eine Zylinderlaufflächenschicht für Hubkolbenmotoren beansprucht, wobei diese Schicht durch ein Plasmaspritzverfahren aufgebracht worden ist. Die so hergestellte Schicht besitzt einen Anteil an gebundenem Sauerstoff zwischen 0.5 bis 8 Gew.-% und weist eingelagerte FeO und Fe2O3 Kristalle auf. Zudem hat die Schicht einen Porositätsgrad zwischen 0.5 und 10% und wird durch honen auf eine bestimmte Rauigkeit gebracht. Die in der Schicht befindlichen Poren bilden Mikrokammern, die als Reservoir für Schmierstoff dienen und die eine gleichmässige Ölverteilung im tribologischen System fördern.

In WO 2015/128178 A1 wird die Oberflächenbehandlung eines Kolbenrings beschrieben, die aus einer Kombination von Oberflächennitrierung und PVD-Beschichtung besteht. Die Lauffläche des Kolbenrings zur Zylinderlauffläche wird mit einer CrN-Schicht belegt, vorzugsweise abgeschieden mit Ion Plating. Alle anderen Oberflächen werden einem Nitrierverfahren unterzogen. Die Abscheidung der PVD-Schicht auf der nicht nitrierten Kolbenringoberfläche soll vor allem einer Rissbildung in der Beschichtung vorbeugen.

US 2014/0260 959 A1 beansprucht einen beschichteten Kolbenring aus Eisen-basierendem Material, auf dessen Oberfläche eine verschleissfeste Schicht abgeschieden wird, die Al5Fe2 enthält und die eine hohe Härte aufweist. Weiterhin wird eine chemische Zusammensetzung dieser Schicht aus 52 bis 55 Gew.-% Al und 45 bis 48 Gew.-% Fe beansprucht.

US 7,406,940 B2 beschreibt ein tribologisches System bestehend aus einem Kolben und einer Zylinderlauffläche, wobei der Kolben noch Aussparungen für Kolbenringe besitzt, die im tribologischen Kontakt mit dem Zylinderliner stehen. Zusätzlich wird das Kolbenhemd so ausgeführt, dass es in seiner Oberfläche eine Grabenstruktur aufweist, um den Schmierfilm zu verbessern. Kolbenring und Kolbenhemd werden zudem noch mit einer DLC-Schicht beschichtet, um die Gleiteigenschaften zu verbessern, vor allem im Zusammenhang mit und angepasst auf eine Vielzahl von Schmierstoffen.

JP 2006 328463 A beschreibt eine Beschichtung von Gleitelementen, wobei ein erstes Element eine Chromoxydschicht aufweist und ein zweites Element eine amorphe Kohlenstoffschicht (*diamond-like carbon film*).

JP S62 280339 A beschreibt eine Zylinderlauffläche aus einer Aluminium- oder Magnesiumlegierung sowie einer Schicht, die auf einem Kolbenring durch thermisches Spritzverfahren gebildet ist.

WO 2008/043606 A1 beschreibt ein PVD-Schichtsystem zum Beschichten von Werkstücken, das zumindest eine Mischkristallschicht eines Mehrfachoxids umfasst.

Die Beispiele belegen, dass Oberflächen beschichtet werden, um deren Verschleiss zu verringern und die Reibverluste zu vermindern. Eine Vielzahl von Beschichtungsmaterialien kann genutzt werden, um das zu erreichen. Unterschiedliche Verfahren werden benutzt, um diese Materialien auf die Substratoberflächen aufzubringen. Zudem wird aus dem Stand der Technik deutlich, dass sehr unterschiedliche Substratmaterialien beschichtet werden müssen, um vorteilhafte Oberflächenanpassungen der Partner im Tribokontakt unter den jeweiligen Bedingungen zu realisieren.

In einigen Fällen diktiert auch die Geometrie der zu beschichtenden Komponente das Beschichtungsverfahren. Beispielsweise ist das der Fall, wenn Zylinderbohrungen beschichtet werden müssen. Für eine solche Beschichtung des inneren Teils dieser Komponente eignet sich ein Spritzverfahren weitaus besser als ein PVD-Verfahren. Auch in Fällen, bei denen dickere Schichten über 100 µm oder sogar über 500 µm abgeschieden werden müssen, sind solche Verfahren weitaus effektiver als eine PVD-Beschichtung. Letztere wiederum besitzt wirtschaftliche Vorteile bei dünneren Schichten im Bereich bis 10 µm oder bis 30 µm, falls die Substrate in einem Batchprozess beschichtet werden können.

Das Austesten der Schichtpaarungen eines speziellen tribologischen Systems bezüglich Verschleiss und Reibverlusten ließe sich natürlich am besten am realen Verbrennungsmotor durchführen. Diese Tests sind allerdings zu kostenintensiv, um sie für alle möglichen Materialkombinationen durchzuführen. Zudem bestünde auch das Risiko, dass unbekannte Materialkombinationen zu Schäden im Verbrennungsmotor führen können, was in einer Zerstörung des gesamten Teststands resultieren kann.

Das eben Gesagte zeigt sowohl die Vielfalt an Möglichkeiten und macht deutlich, wie schwer es ist, eine Auswahl von Schichten und Schichtpaarungen zu treffen.

Es besteht also die Aufgabe ein verbessertes tribologisches System, insbesondere für Verbrennungsmotoren, zur Verfügung zu stellen, bei dem zwei Körper jeweils Komponenten eines Verbrennungsmotors bilden und an deren Oberflächen zwei Stoffbereiche ausgebildet sind, die sich im Betrieb wenigstens bereichsweise berühren und einen tribologischen Kontakt bilden. Insbesondere besteht Bedarf, die tribologischen Systeme, die aus Kolbenring und Zylinder bzw. aus Zylinder und Kolben gebildet werden, zu verbessern. Dabei besteht insbesondere auch die Aufgabe, weitere Werkstoffe bzw. Werkstoffpaarungen bereitzustellen, aus denen die als Schichten ausgebildeten Stoffbereiche hergestellt werden können.

### ZUSAMMENFASSUNG

Nach einem ersten Aspekt stellt die vorliegende Offenbarung ein tribologisches System mit einem ersten und einem zweiten Körper zur Verfügung, die jeweils eine Komponente eines Verbrennungsmotors bilden, insbesondere Kolben, Kolbenring oder Zylinder, und deren Oberflächen einen ersten und zweiten Stoffbereich aufweisen, die sich im Betrieb wenigstens bereichsweise berühren und einen tribologischen Kontakt bilden, wobei der erste Stoffbereich an einem als Kolbenring ausgebildeten ersten Körper eine Aluminiumchromoxyd-basierende Schicht mit einer chemischen Zusammensetzung von (Al1-xCr y)2O3 ist, wobei gilt: 0,1 ≤ x ≤ 1 und y ≤ 0,5; 0.5 ≤ x ≤ 1 und y ≤ 0.5 oder x= 0,7 und y= 0.3, und der zweite Stoffbereich an einem als Zylinder ausgebildeten zweiten Körper eine Aluminium-Chromoxid-Mischschicht mit einer Zusammensetzung von 10 Gew.-% bis unter 100 Gew.-% Cr2O3 und entsprechend mehr als 0 Gew.-% bis 90 Gew.-% Al2O3 ist.

Weitere Aspekte und Merkmale ergeben sich aus den abhängigen Ansprüchen, der beigefügten Zeichnung und der nachfolgenden Beschreibung von Ausführungsformen.

### KURZBESCHREIBUNG DER ZEICHNUNG

Ausführungsformen werden nun beispielhaft und unter Bezugnahme auf die beigefügte Zeichnung beschrieben. Darin zeigt:
- Fig. 1: eine schematische Schnittdarstellung mit Komponenten aus einem erfindungsgemäßen Verbrennungsmotor, der erfindungsgemäße tribologische Systeme aufweist;
- Fig. 1A: einen vergrößerten Ausschnitt A aus Figur 1, der ein erstes erfindungsgemäßes tribologisches System zeigt, das aus einem Zylinder und einem Kolbenring gebildet ist;
- Fig. 1B: einen vergrößerten Ausschnitt B aus Figur 1, der ein zweites erfindungsgemäßes tribologisches System zeigt, das aus einem Zylinder und einem Kolben gebildet wird;
- Fig. 1C: ein Detail C aus Figur 1, das einen Zylinderboden mit einer Beschichtung zeigt;
- Fig. 2: eine schematische Darstellung einer SRV-Testanordung für einen trockenen Test (linke Darstellung) und einen geschmierten Test (rechte Darstellung) für einen tribologischen Versuch zur Ermittlung einer für ein erfindungsgemäßes tribologisches System geeigneten Beschichtung;
- Fig. 3: den zeitlichen Verlauf der Reibungskoeffizienten für einen Referenzwerkstoff A1 und einen Al-CrO-Werkstoff D2 mit einem Gegenkörper aus einem Stahlwerkstoff;
- Fig. 4: den beobachteten und vermessenen Verschleiß der Werkstoffe aus Figur 3;
- Fig.5: den Verschleiß des Gegenkörpers beim SRV-Test mit den in Figur 3 und 4 dargestellten Schichten;
- Fig. 6: den zeitlichen Verlauf der Reibungskoeffizienten, der in den Figuren 3-5 dargestellten Werkstoffe A1 und D2 mit einem Gegenkörper aus Aluminiumoxyd;
- Fig. 7: den beobachteten und vermessenen Verschleiß der Schichten A1 und D2 mit dem Gegenkörper gemäß Fig. 6;
- Fig. 8: den Verschleiß des Gegenkörpers nach dem SRV-Test unter trockenen Bedingungen im Kontakt mit den Beschichtungen A1 und D2;
- Fig. 9: den zeitlichen Verlauf des Reibungskoeffizienten von A1 und D2 mit einer Stahlkugel als Gegenkörper unter geschmierten Testbedingungen mit einem ersten Schmiermittel;
- Fig. 10: den Verschleiß der Schichten A1 und D2 nach dem SRV-Test unter geschmierten Bedingungen gemäß Figur 9;
- Fig. 11: den Verschleiß des Stahlgegenkörpers nach dem in Figur 9 und 10 dargestellten SRV-Test;
- Fig. 12: den zeitlichen Verlauf des Reibungskoeffizienten von A1 und D2 mit einer Aluminiumoxydkugel als Gegenkörper unter geschmierten Testbedingungen mit einem ersten Schmiermittel;
- Fig. 13: den Verschleiß der Schichten A1 und D2 nach den SRV-Test unter geschmierten Bedingungen gemäß Figur 11 und 12;
- Fig. 14: den Verschleiß des Gegenkörpers nach dem SRV-Test unter geschmierten Bedingungen gemäß Figur 11-13;
- Fig. 15A bis 15C: den zeitlichen Verlauf der Reibungskoeffizienten für die Werkstoffe A1, D1 und D2 für einen geschmierten SRV-Test mit einem Aluminiumoxydgegenköper bei Raumtemperatur (Fig. 15A) bei 100 Grad Celsius (Fig. 15B) und bei 160 Grad Celsius (Fig. 15C) und
- Fig. 16: den Vergleich des Schicht- und Gegenköperverschleißes für die in Figur 15A und 15C dargestellten geschmierten SRV-Test für die Schichtsysteme A1 und D2.

### BESCHREIBUNG VON AUSFÜHRUNGSFORMEN

Vor einer detaillierten Beschreibung der Ausführungsform unter Bezugnahme auf Figuren folgen zunächst allgemeine Erläuterungen zu den Ausführungsformen.

Eine Ausführungsform bei der das tribologische System einen ersten und einen zweiten Körper aufweist, die jeweils eine Komponente eines Verbrennungsmotors bilden, insbesondere Kolben, Kolbenring oder Zylinder, und deren Oberflächen einen ersten und zweiten Stoffbereich aufweisen, die sich im Betrieb wenigstens bereichsweise berühren und einen tribologischen Kontakt bilden und bei dem der erste und/oder der zweite Stoffbereich als eine Chromoxyd- oder Aluminiumchromoxyd basierende Schicht ausgebildet ist, weist Eigenschaften auf, die insbesondere für die kritischen brennraumnahen tribologischen Systeme in einem Verbrennungsmotor günstig sind.

Chromoxyd- oder Aluminiumchromoxyd- basierende Schichten lassen sich in unterschiedlichen Verfahren auf unterschiedliche Werkstoffe, inklusive auf kompakte Materialienaufbringen, die typisch im Verbrennungsmotorbereich sind.

Stahl (z.B. der Qualität 42CrMo4) ist ein typischer Werkstoff, aus dem Kolben gefertigt werden. Weitere typische Werkstoffe für die Kolben und deren Laufflächen am Kolbenstutzen (auch Kolbenhemd) sind beispielsweise peritektische Aluminium-Siliziumlegierungen mit 11-13% Si und kleineren Zusätzen von Cu, Mg, und Ni. Es gibt auch Leichtmetallverbundwerkstoffe, bei denen Verstärkungselemente, zum Beispiel aus Keramik, Kohlenstofffasern und porösen metallischen Werkstoffen in besonders hoch belasteten Kolbenregionen gezielt angeordnet werden.

Die Zylinder sind meist Bestandteil des Kurbelgehäuses und können in Monometallbauart, beispielsweise aus Gusseisenlegierungen oder Aluminium-Siliziumlegierungen hergestellt werden. Bei solchen Zylindern werden die Laufflächen direkt am Gusswerkstoff ausgebildet.

Bei der sogenannten Einsatztechnik werden Zylinderbuchsen in das Kurbelgehäuse eingesetzt. Dabei werden die Buchsen aus GG-Werkstoffen, Aluminiumwerkstoffen oder auch Aluminium-Siliziumlegierungen hergestellt und in das Kurbelgehäuse in dafür entsprechend bearbeitete Aufnahmen eingeschoben bzw. eingepresst, eingeschrumpft oder auch eingegossen.

In der sogenannten Verbundtechnik werden zylindrische Formkörper aus einem Verbund aus geeigneten metallischen und keramischen Werkstoffen in die Gießform eingelegt und von der das Kurbelgehäuse bildenden Aluminiumlegierungsschmelze unter hohem Druck infiltriert.

Bei allen Zylindern werden die Zylinderlaufflächen als tribologischer Laufpartner und Dichtfläche für Kolben und Kolbenringe durch Feinbohren oder- drehen und einer anschließenden Honbearbeitung ausgeführt.

Für die Kolbenringe, die als metallische Dichtung dienen und den Brennraum gegen das Kurbelgehäuse abdichten, gibt es eine Vielzahl von Bauarten und Werkstoffen. Weit verbreitet sind Stahloder Graugusswerkstoffe. Dabei ist es auch üblich, die Ringlaufflächen, die mit der Zylinderlaufbahn ein tribologisches System bilden, mit verschleißfesten Schutzschichten zu bewehren. Neben den bereits erwähnten Beschichtungen für die Ringlaufflächen sind Verchromungen, Chrom-Keramik Schichten, Chrom-Diamant Schichten oder auch Molybdän-basierende Beschichtungen vorgesehen. In Nitrier- bzw. Nitrocarborierverfahren können durch Diffusion Stickstoff und zum Teil auch Kohlenstoff in die Oberfläche des Kolbenringes eingelagert werden.

Es gibt Ausführungen, bei denen der als Beschichtung ausgebildete erste und zweite Stoffbereich jeweils an einer eine Lauffläche bildenden Oberfläche der Komponenten angeordnet sind. Bei den Bauteilen Kolben, Kolbenring oder Zylinder sind dies die Kolbenschaftlaufbahnen am Kolben, die Ringlaufflächen an den Kolbenringen und die Zylinderlaufbahnen an der Innenseite der Zylinder. Diese die jeweiligen Laufflächen bildenden Oberflächen bilden jeweils paarweise ein erfindungsgemäßes tribologisches System und können als Chromoxyd- oder Aluminiumchromoxyd basierende Schicht ausgebildet sein.

Erfindungsgemäß ist der erste Stoffbereich an einem als Kolbenring ausgebildeten ersten Körper eine Aluminiumchromoxyd-basierende Schicht mit einer chemischen Zusammensetzung von (Al1-xCr y)2O3 für die gilt: 0,1 ≤ x ≤ 1 und y ≤ 0,5; 0.5 ≤ x ≤ 1 und y ≤ 0.5 oder x = 0,7 und y = 0.3. So eine Beschichtung zeigt positive tribologische Eigenschaften sowohl im trockenen als auch im geschmierten Zustand für unterschiedliche Reibungspartner (zweiter Stoffbereich an der Zylinderlauffläche).

Erfindungsgemäß ist der zweite Stoffbereich an einem als Zylinder ausgebildeten zweiten Körper eine eine Aluminiumoxid-Chromoxid Mischschicht mit einer Zusammensetzung von 10 Gew-% bis unter 100 Gew-% Cr2O3 und entsprechend mehr als 0 Gew-% bis 90 Gew-% Al2O3. So eine Schicht ist mit geeigneten Beschichtungsverfahren (z.B. mittels thermisches Spritzen) auf eine Zylinderlauffläche aufzubringen und bildet einen guten tribologischen Partner zu einer anderen Aluminiumchromoxyd basierenden Schicht (durch den ersten Stoffbereich gebildet) mit der oben angegebenen Zusammensetzung von (Al1-xCr y)2O3.

Es gibt Ausführungen, bei denen die tribologischen Eigenschaften durch eine günstige Beeinflussung der Oberflächenrauigkeiten weitet verbessert werden können. Dabei gelten für die ersten Stoffbereiche folgende Werte für die Oberflächenrauigkeit Ra in µm: 0,1 ≤ Ra ≤ 0,5; 0,15 ≤ Ra ≤ 0,4; Ra = 0,15 oder Ra = 0,4 und für die zweiten Stoffbereiche folgende Werte: 0,1 ≤ Ra ≤ 0,5; 0,15 ≤ Ra ≤ 0,45; Ra = 0,15 oder Ra = 0,45.

Dabei gibt es Ausführungen, bei denen die Stoffbereiche mittels eines thermischen Spritzverfahrens ausgebildet sind. Dabei wird ein Spritzwerkstoff (dies kann z.B. eine Pulvermischung mit unterschiedlichen Bestandteilen wie Al2O3 und Cr2O3 sein) in eine konzentrierte, energiereiche Wärmequelle eingebracht, dort auf- bzw. angeschmolzen und in Form von Spritzpartikeln mit hoher Geschwindigkeit auf die Oberfläche des zu beschichtenden Substrats geschleudert. Dieses Verfahren ist insbesondere zur Beschichtung größerer Flächen wie der Zylinderlauffläche oder auch der Kolbenschaftlaufbahn geeignet. Verbreitete Verfahren sind das Flammspritzen, das Hochgeschwindigkeitsflammspritzen (HVOF), das sogenannte Kaltgasspritzen, das Lichtbogenspritzen und das Plasmaspritzen. Die sich ergebende Zusammensetzung der Schicht entspricht etwa der Zusammensetzung des Ausgangswerkstoffes (der Pulvermischung).

Schichtdicken beim thermischen Spritzen betragen zwischen 50mm und 400 mm insbesondere auch zwischen 150 µm und 800 µm.

Es gibt auch Ausführungen, bei denen einer der Stoffe mittels eines PVD-Verfahrens (Physical Vapour Deposition) und insbesondere mittels kathodischer Funkenverdampfung ausgebildet ist. Bei den bekannten PVD Prozessen werden durch das Abscheiden von Ionen, Atomen oder Molekülen aus der Gasphase oder einem Plasma tribologische Schutzschichten auf der Oberfläche des Substrates (Grundwerkstoff des zu beschichteten Bauteiles) ausgebildet. Dazu werden die erforderlichen Ausgangsmaterialien (z.B. Metalle, Keramiken etc.) thermisch verdampft oder zerstäubt und auf den Bauteilen wieder kondensiert.

Sowohl die sogenannte kathodische Funkenverdampfung als auch das sogenannte Kathodenzerstäuben (oder MSIP-Magnetron Sputter Ion Plating) sind seit längerem etablierte Verfahren, die zur Beschichtung von Werkzeugen und Bauteilen Anwendung finden und mit denen unterschiedlichste Schichten abgeschieden werden können.

Dabei gibt es beispielweise Ausführungen, bei denen die mittels eines PVD Verfahrens ausgebildeten Stoffbereiche eine Schichtdicke zwischen 10 und 30 µm aufweisen.

Es gibt auch nicht erfindungsgemäße Ausführungen, bei denen ein Stoffbereich als eine Mo, MoN, MoCuN-, DLC- oder ta-C basierende Schicht ausgebildet ist und ein Stoffbereich als eine Chromoxyd- oder Aluminiumchromoxyd basierende Schicht.

Mo-, MoN- und MoCuN sind widerstandsfähige und die tribologischen Eigenschaften verbessernde Schichten.

DLC (Diamond Like Carbon) -schichten umfassen in der Regel sogenannte Dünnschichtsysteme, die im Wesentlichen aus Kohlenstoff bestehen und mittels PVD- oder CVD (Chemical Vapour Deposition)-Verfahren aufgetragen werden. Es handelt sich dabei um graphitische, diamantartige oder amorphe Kohlenstoff- bzw. Kohlenstoffwasserstoff Schichten sowie auch Plasmapolymerschichten. ta-C basierende Schichten sind ebenfalls sogenannte DLC Schichten und zeichnen sich durch ein bestimmtes Verhältnis zwischen graphitisch gebundenem Kohlenstoff und diamantartig gebundenem Kohlenstoff aus, bei denen der diamantartig gebundene Anteil überwiegt. Auch solche ta-C-basierenden Schichten bieten hervorragende tribologische Eigenschaften, insbesondere auch im tribologischen Verbund mit Chromoxyd- oder Aluminiumchromoxyd basierenden Schichten.

Dabei gibt es Ausführungen, bei denen wenigstens eine der Schichten eine Universalhärte von wenigstens 80 GPa aufweist. Die Härte einer Schicht ist oft ein Indiz für die Verschleißfestigkeit.

Die Erfindung betrifft insbesondere einen Verbrennungsmotor mit einem erfindungsgemäßen tribologischen System. Die oben erläuterten tribologischen Systeme sind insbesondere in den thermisch hochbeanspruchten Komponenten mit Gleitreibungsbeanspruchungen im Zylinder-/Kolbenbereich vorteilhaft. Dazu gehört zum einen, das tribologische System zwischen Kolbenring 8/9 (en) und Zylinderlaufbahn sowie das tribologische System, das aus der Kolbenschaftlaufbahn (auch Kolbenhemdlaufbahn) und der Zylinderlaufbahn gebildet werden.

Dabei gibt es Ausführungen, bei denen wenigstens ein weiterer Oberflächenbereich am Kolben vorgesehen ist, der als eine Chromoxyd- oder Aluminiumchromoxyd basierende Schicht ausgebildet ist. Zu diesen Bereichen gehören insbesondere die Kolbenringnutbereiche, der Kolbenboden oder auch der Kolbenschaft. Hier sind thermisch widerstandsfähige und robuste Hartschichten hilfreich, um die hohen Beanspruchungen in diesen Bereichen in das Grundmaterial zu übertragen.

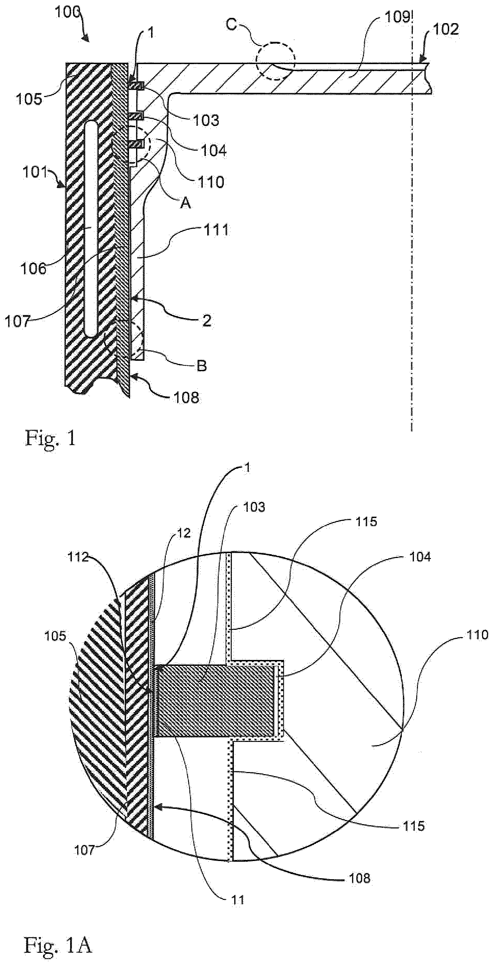

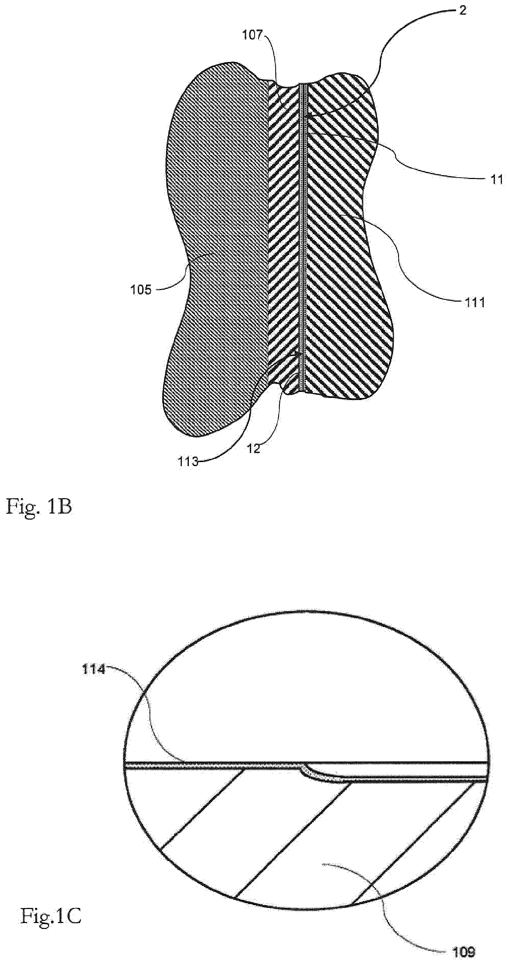

Zurückkommend zu Fig. 1, veranschaulicht diese in einer schematischen Längsschnittdarstellung Komponenten eines Verbrennungsmotors 100 mit einem Zylinder 101, in dem ein im Betrieb oszillierender Kolben 102 angeordnet ist, der mit drei Kolbenringen 103 versehen ist, die in Kolbenringnuten 104 angeordnet sind. Die Zylinderwand 105 weist einen Kühlkanal 106 auf und die eigentliche Zylinderbohrung wird hier durch eine eingesetzte (optionale) Zylinderbuchse 107 gebildet, an deren innerer Oberfläche 108 die Zylinderlaufbahn ausgebildet ist.

Der Kolben 102 weist an seinem oberen Ende den Kolbenboden 109 auf, an den sich ein Zylinderförmiger Kolbenringnutbereich 110 anschließt, der in den Kolbenstutzen 111 übergeht.

Der Zylinder 101 bzw. die Zylinderbuchse 107 (so vorhanden) einerseits und die Kolbenringe 103 bzw. der Kolbenstutzen 111 andererseits bilden hier tribologische Systeme 1 und 2.

Figur 1A zeigt ein tribologisches System 1. Dabei bildet der Kolbenring 103 einen ersten Körper an dessen Oberfläche, wenigstens im Bereich der Ringlauffläche 112 ein erster Stoffbereich 11 als eine Aluminiumchromoxyd basierende Schicht ausgebildet ist, z.B. als Al1-0,7 Cr-0,3)2O3 Schicht. Für andere erfindungsgemäße Zusammensetzungen kann gelten (Al1-xCr y)2O3 wobei gilt: 0,1 ≤ x ≤ 1 und y ≤ 0,5; 0.5 ≤ x ≤ 1 und y ≤ 0.5. Die Schichtdicke beträgt zwischen 10 und 30 µm, und weist eine Härte von wenigstens 18 GPa auf. Die Schicht weist eine Oberflächenrauigkeit (Ra in µm) von Ra=0,15 oder Ra=0,4 auf und liegt bei anderen Ausführungen in einem Bereich, für den gilt: 0,1<Ra<0,5. Andere geeignete Beschichtungen für die Kolbenringe 103 sind in der Tabelle 1b als C2 und D2 benannt.

An der Zylinderlaufbahn 108 ist ein zweiter Stoffbereich 12 als Schicht ausgebildet, die aus einer Aluminiumoxyd und Chromoxyd Mischung ausgebildet ist, und einen Gewichtsanteil von 62 Gew.-% Al203 aufweist und einen Gewichtsanteil von 38 Gew.-% Cr2O3. Die Oberflächenrauigkeit beträgt Ra=0,45 µm (E1 in Tabelle 1a). Alternativ ist der erste Stoffbereich als Chromoxyd (Cr2O3) Schicht ausgebildet, die eine Oberflächenrauigkeit von Ra =0,15 µm aufweist (D1 in Tabelle 1a).

Alternativ ist der zweite Stoffbereich 12 aus einer Aluminiumchromoxyd Schicht ausgebildet, bei der der Chromoxydanteil einen Gew.-% Anteil von 10 bis unter 100 ausmacht und der Aluminiumoxydanteil einen entsprechenden komplementären Gew.-% Anteil von mehr als 0 bis 90. Andere, nicht erfindungsgemäße Beschichtungen für den zweiten Stoffbereich können auch die in der Tabelle 1a mit A1, B1 und C1 bezeichneten Schichtsysteme sein.

Der oder die Kolbenringe 103 (erster Körper) und der Zylinder 105 bzw. die Zylinderbuchse 107 (zweiter Körper) bilden also mit den sich berührenden Flächen 112 und 108 bzw. dem oder den ersten Stoffbereichen 11 und dem zweiten Stoffbereich 12 ein tribologisches System, bei dem die sich berührenden Flächen im Betrieb gleitend aneinander reiben.

Dabei gibt es Betriebszustände, bei denen eine weitgehend trockene Reibung stattfindet, nämlich am oberen und unteren Totpunkt des Kolbens, an denen die Kolbengeschwindigkeit niedrig oder sogar gleich Null ist. Der durch das Motoröl gebildete Schmierfilm zwischen den beiden Flächen bricht dann weitgehend ab.

Eine nasse bzw. geschmierte Reibung tritt während der oszillierenden Bewegung des Kolbens zwischen den Umkehrpunkten auf. Das Motoröl bildet dann einen wirksamen Schmierfilm zwischen den Stoffbereichen 11 und 12, der Reibung und Verschleiß stark herabsetzt.

Es können auch Mischreibungszustände auftreten, bei denen Schmiermittel nicht als vollständiger Film zwischen den Stoffbreichen 11 und 12 vorhanden ist, sondern in Vertiefungen in der Oberfläche. Diese Schmierwirkung kann bei höherer Oberflächenrauigkeit stärker sein (z.B. an gehonten Flächen) als bei glatteren Oberflächen mit niedrigerer Oberflächenrauigkeit (z.B. polierte oder gebürstete Flächen), die ein geringeres Schmiermittelaufnahmevermögen haben.

Ein zweites tribologisches System 2 (in der Figur 1B erkennbar). Die Detaildarstellung 1B zeigt den Kolbenstutzen 111 an dessen Oberfläche 113 ein erster Stoffbereich 11 ausgebildet ist, der mit einer Beschichtung versehen ist, die in der Tabelle 1a mit A1, B1,C1, D1 (alle nicht erfindungsgemäß) oder E1 (erfindungsgemäß) bezeichnet sind. Alternativ kann die Oberfläche 113 aber auch eine andere Beschichtung aufweisen, die oben im Zusammenhang mit der Beschichtung der Zylinderlaufbahn 108 beschrieben ist. Auch hier tritt, ähnlich wie beim ersten tribologischen System 1, im Betrieb eine trockene, geschmierte oder Mischreibung auf, die vom Bewegungszustand des Kolbens 102 im Zylinder 105 abhängt.

Weitere optionale Beschichtungen können auch in anderen Oberflächenbereichen des Kolbens vorgesehen werden. Zum einen am Kolbenboden (siehe dazu Figur 1C), der zur Verbesserung der thermischen und drucktechnischen Belastbarkeit mit einer Schicht 114 versehen sein kann. Eine weitere Schicht 115 kann auch im Kolbenringnutbereich 110 insbesondere im Bereich der Kolbenringnuten 104 vorgesehen werden. Hier kommen zum einen die in der Tabelle 1a angegebenen Schichten A1, B1, C1, D1, D1 (alle nicht erfindungsgemäß) und E1 (erfindungsgemäß) E1 in Frage, aber nicht erfindungsgemäß auch Molybdän-, Molybdänstickstoff-, Molybdänkupferstickstoff-, DLC oder ta-C basierende Schichten in Frage.

Weiterhin gilt nicht erfindungsgemäß auch, dass beispielsweise für den Fall, dass die Kolbenringe 103 mit einer Chromoxydoder Aluminiumchromoxyd- basierenden Schicht versehen sind (im ersten Stoffbereich 11), die damit zusammenwirkende Schicht (zweiter Stoffbereich 12) an der Zylinderlaufbahn 108 als eine Mo-MoN-, MoCuN-, DLC- oder ta-C-basierende Schicht ausgebildet sein kann.

Umgekehrt gilt auch, für den Fall, in dem der oder die Kolbenringe 103 mit so einer Schicht versehen sind, dass dann die Zylinderlaufbahn 108 mit einer Chromoxyd- oder Aluminiumchromoxyd-basierenden Schicht versehen ist, insbesondere mit einer solchen, deren Eigenschaften weiter oben oder nachfolgend im Detail beschrieben ist.

Gleiches gilt für das tribologische System, das von Zylinderlaufbahn 111 mit der Kolbenschaftlaufbahn 113 gebildet wird.

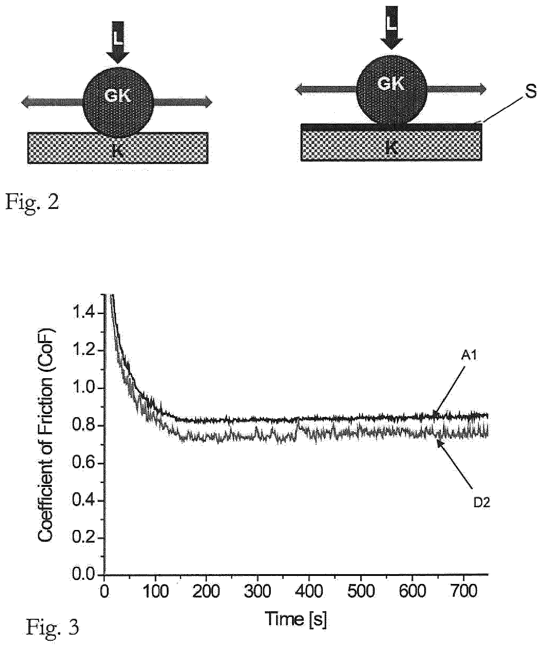

Nachfolgend wird nun anhand der Figuren 2 bis 16 ein Test mit zugehörigem Versuchsaufbau und einigen Versuchsergebnissen beschrieben, die unter anderem zu den oben beschriebenen erfindungsgemäßen Ausführungsformen geführt haben.

Ein wichtiger Test dieser Art ist der Schwingungs-Reibungs-Verschleiss (SRV)-Test (DIN 51834), mit dem sich das Verschleiss- und Reibverhalten von Materialien charakterisieren lässt. Man kann mit diesen Tests viele tribologische Situationen der späteren Anwendung nachstellen, sodass man eine sinnvolle Vorauswahl der Beschichtungen von Körper und Gegenkörper treffen kann. Somit ist es möglich, im realen Verbrennungsmotor mit einer zumeist schon einigermaßen optimierten Lösung bei der Auswahl der Beschichtungen zu arbeiten, so dass dann nur noch Feinanpassungen notwendig sind. Erreicht wird das dadurch, dass die Parameter des SRV-Tests, wie beispielsweise Kontaktdruck oder Temperatur, so nachgestellt werden, dass das Ergebnis des Tests die Resultate bereits durchgeführter Motorentests widerspiegelt.

Ein solcher SRV-Test wurde für die erfindungsgemäßen Untersuchungen benutzt, und die Parameter für den Test wurden so gewählt, dass Mangelschmierung im tribologischen Kontakt nachgestellt wurde. Die Parameter wurden sowohl für den Fall der Mangelschmierung verwendet, aber auch für den Fall, bei dem der Test "trocken", also ohne Schmiermittel, durchgeführt wurde. Ein solcher Test liefert erfahrungsgemäß Aussagen über zwei grundsätzliche Verschleissverhalten. Im trockenen Test wird vor allem das Aufschmierverhalten der Partner im tribologischen Kontakt untersucht und der relative Verschleiss der Tribopartner deutlich. Die geschmierten Tests unter diesem hohen Kontaktdruck simulieren Mangelschmierung. Diese Testbedingungen geben Aufschluss über den Verschleiss der Tribopartner und liefern auch Reibungskoeffizienten, die relative Vergleiche der Materialkombinationen zulassen.

Es wurden in den Experimenten verschiedene Schichtmaterialien untersucht. Die Auswahl der Schichten wurde im Hinblick auf eine Weiterentwicklung und Verbesserung des tribologischen Kontakts zwischen Kolbenring und Zylinderlaufbahn eines Verbrennungsmotors durchgeführt, d.h. die Schichten wurden in einer ersten Gruppe 1 mit einem thermischen Spritzverfahren hergestellt und in einer zweiten Gruppe 2 mittels eines PVD-Verfahrens, bevorzugt mit Sputtern und noch bevorzugter mit reaktiver kathodischer Funkenverdampfung.

Mit beiden Beschichtungsverfahren wurden Probekörper beschichtet und zwar wurden die Probekörper der Gruppe 1 mit Schichten versehen, die sich erfahrungsgemäß gut für die Anwendung auf Zylinderlaufbahnen eignen oder die für diese Anwendung untersucht werden sollten.

Die Probekörper der Gruppe 2 wurden mit Materialien beschichtet, die sich erfahrungsgemäß für Kolbenringbeschichtungen eignen oder von denen die Eigenschaften für eine solche Anwendung abgeklärt werden sollten. Die Schichten wurden auf planaren Probekörpern abgeschieden und teilweise nachbehandelt. Der Test erfolgte sowohl mit Gegenkörpern aus Stahl (100Cr6) als auch Aluminiumoxyd.

Figur 2 zeigt den schematischen Aufbau der Apparatur, die für die Durchführung der SRV-Tests benutzt wurde und beschreibt die im Text verwendeten Begriffe. Die Tests wurden für eine weit grössere Zahl von Schichtmaterialien durchgeführt, die aber nicht alle hier besprochen werden.

Zwei wichtige technische Ziele, die bei den Entwicklungen auf dem Gebiet der Verbrennungsmotoren angestrebt werden, sind Verschleissreduktion, um die Lebensdauer der Komponenten und die Serviceintervallzeiten zu vergrössern, und die Verringerung der Reibungsverluste, um den Wirkungsgrad zu verbessern.

Ein wichtiger Aspekt betrifft auch die Temperaturstabilität der im Verbrennungsmotor verwendeten Materialien. Hier besteht der Trend, dass diese verbessert wird, damit der Verbrennungsprozess bei höheren Temperaturen stattfinden kann, um auch damit die Effizienz des Motors zu erhöhen. Die Suche nach temperaturstabilen Schichtmaterialien, die die kompakte Materialoberfläche bei diesen höheren Temperaturen schützen und sowohl bei Umgebungstemperatur als auch bei den hohen Temperaturen gute tribologische Eigenschaften besitzen, war ein weiterer wichtiger Grund dieser Untersuchungen.

Figur 2 beschreibt das Prinzip des SRV-Tests unter trockenen (links) und geschmierten (rechts) Bedingungen. Das tribologische System oder Tribosystem besteht aus zwei Tribopartnern - dem Körper (K) und dem Gegenkörper (GK). Während der K mit einer Beschichtung belegt ist, wurde in den Experimenten kugelförmige polierte GK aus Stahl (100Cr6) und Aluminiumoxyd verwendet. K ist fest in eine Unterlage eingespannt und kann geheizt werden. GK wird mit horizontalen Oszillationen über K durch die mit den zwei Pfeilen angedeuteten Kräfte oszillierend über die beschichtete Oberfläche von K bewegt und gleichzeitig mit einer Last L beaufschlagt. Im geschmierten Test (rechts) wird dieser Oszillation ein Schmiermittel S beigegeben.

### Beschreibung der Experimente

In Tabelle 1a und b sind die Schichtmaterialien angegeben, die getestet wurden. Bei diesen handelt es sich teilweise um bereits technisch eingeführte Materialien oder um solche, die sich bereits für Motorentests qualifiziert haben (A1, B1, C1).

Zusätzlich wurden noch weitere Materialien getestet, von denen die tribologischen Eigenschaften nicht bekannt waren, die aber eine verbesserte Temperaturstabilität versprachen (D1 (nicht erfindungsgemäß), E1, C2, D2).

Diese Materialien sind vor allem oxydischen Ursprungs und sind teilweise Inhalt der Erfindung. Die Tabellen 1a und b listen nur einen Teil dieser getesteten Materialien auf und geben auch die Oberflächenrauigkeit an, die diese Schichten hatten. Diese hängt selbstverständlich von den unterschiedlichen Nachbehandlungen ab.

Für diese Nachbehandlungen wurden in diesen Untersuchungen nur gängige Verfahren benutzt, also etwa das Honen, Schleifen oder Bürsten, damit eine technische Umsetzung der Erfindung nicht nur für die Beschichtung sondern auch für die Nachbehandlung gesichert ist. Die Tabelle gruppiert die Schichtmaterialien nach den Beschichtungsverfahren, d.h. die Schichten für die die Anwendung auf der Zylinderlaufbahn vorgesehen ist, sind in Tabelle 1a angegeben, diejenigen, die für die Beschichtung der Kolbenringe gedacht sind, sind in Tabelle 1b angegeben. Diese Trennung wurde deshalb vorgenommen, weil die verschiedenen Beschichtungsverfahren sich unterschiedlich gut für die Beschichtung von Ring und Liner eignen, sie soll aber nicht als Beschränkung aufgefasst werden.

Ausserdem ist es nicht zwingend, dass Schichtmaterialien mit gleicher chemischer Zusammensetzung, die in den unterschiedlichen Beschichtungsverfahren hergestellt wurden, auch die gleichen Eigenschaften im tribologischen System aufweisen. Das kann beispielsweise in unterschiedlichen Schichtdicken oder an den mechanischen Eigenschaften der Schichten in Bezug auf deren Porosität oder Eigenspannung liegen. Für die Schichten auf den Zylinderlaufflächen wurden thermische Spritzverfahren verwendet, und es wurden Schichten mit Dicken zwischen 150 µm und 800 µm hergestellt. Für die Beschichtung der Kolbenringmaterialien wurde ein PVD-Verfahren verwendet, das für die hier ausgewählten Schichten die reaktive kathodische Funkenverdampfung war, obwohl auch andere Beschichtungsverfahren wie z.B. das thermische Verdampfen oder Sputtern dafür benutzt werden können.

Beschichtet wurden ebene Proben. Alle Proben, die mittels thermischer Spritzverfahren hergestellt wurden, wurden so nachbehandelt, dass sie eine Oberflächenrauigkeit hatten, die dem standardmässigen Honen entspricht, das in der Produktion zur Nachbehandlung der thermisch gespritzten Zylinderlaufbahnen angewandt wird.

Die mittels Funkenverdampfung hergestellten Schichten wurden entweder nicht oder in einem Standardbürstverfahren nachbehandelt. Die Zuordnung zu dem Herstellungsverfahren, eine Auswahl und genauere Beschreibung der Schichtmaterialien und die Art der Nachbehandlung und die daraus resultierenden Oberflächenrauigkeiten sind ebenfalls in Tabelle 1a und b angegeben.

Als Gegenkörper in den SRV-Tests wurden polierte Kugeln aus Stahl (100Cr6) und aus Aluminiumoxyd verwendet. Die Tests wurden sowohl trocken und mit zwei verschiedenen Ölen geschmiert durchgeführt. Es wurde bei Umgebungstemperatur und für Temperaturen bis zu 160°C, nahe der Stabilitätsgrenze des verwendeten Schmiermittels, getestet, um damit auch die Stabilität der Schichten bei höheren Temperaturen zu untersuchen.

Die Tests lieferten folgende Resultate:
1. Den Verlauf des Reibungskoeffizienten als Funktion der Zeit
2. Den Verschleiss der Beschichtung unter den verschiedenen Bedingungen
3. Den Verschleiss des Gegenkörpers unter den verschiedenen Bedingungen

Die Resultate werden in tabellarischer Form angegeben. Für den Reibungskoeffizient wird der Wert in die Tabelle übernommen, der sich am Ende des jeweiligen Tests ergibt. Die Bewertung des Verschleisses von Beschichtung und Gegenkörper basiert auf der optischen Einschätzung von lichtmikroskopischen Verschleissbildern und der quantitativen Auswertung von optisch abgetasteten Oberflächenprofilen. Zum besseren Verständnis der in tabellarischer Form angegebenen Werte wird für alle Arten der Resultate und der untersuchten Bedingungen im SRV-Test ein Beispiel angegeben.

Figur 3 zeigt den zeitlichen Verlauf des Reibungskoeffizienten für die Schicht aus dem nachbehandelten niedrig legierten Stahl (A1) und der polierten Al-Cr-O Schicht (D2) mit der polierten Stahlkugel als Gegenkörper. Der SRV-Test wurde trocken, also ungeschmiert, durchgeführt. Man sieht, dass der Reibungskoeffizient sich am Ende der Messzeit bei 0.86 für A1 und bei 0,76 für D2 einstellt. Das Rauschen der Kurve D2 ist stärker bei der Oxydschicht als beim niedrig legierten Eisen.

Unter diesen Testbedingungen besitzt das tribologische System für einen Fachmann Werte für den Reibungskoeffizienten, die auf ein "Fressen" im tribologischen Kontakt hinweisen. Solche müssen für die hier diskutierten Anwendungen vermieden werden.

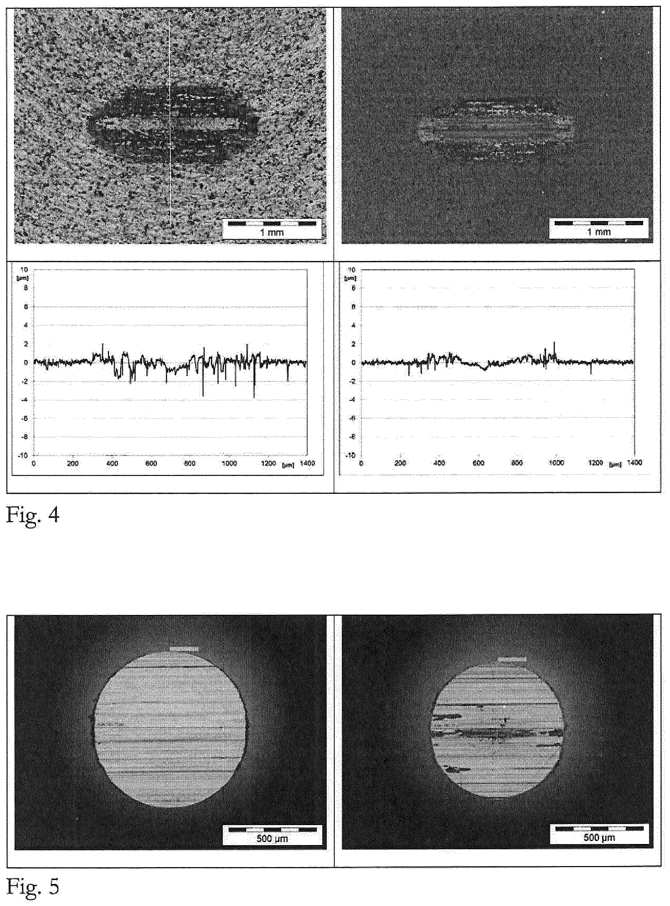

In Figur 4 wird der Schichtverschleiss gezeigt. Dafür wurden lichtmikroskopische Aufnahmen der Schichtoberfläche nach dem Test angefertigt (obere Bildreihe). Man sieht eine deutliche Veränderung der Schichtoberfläche in dem Bereich, in welchem sich die oszillierende Stahlkugel bewegt hat und der etwa 1mm lang ist. Mittels EDX-Messungen kann man das Material des Gegenkörpers (100Cr6) sowohl auf A1 wie auch auf D2 nachweisen, d.h. es erfolgte ein Materialübertrag des Gegenkörpers auf die Schicht (Aufschmieren), was auf einen Verschleiss des Gegenkörpers hinweist.

Um den Schichtverschleiss näher zu charakterisieren, wurde die Oberfläche senkrecht zur oszillierenden Bewegungsrichtung, wie es durch die weiße Linie in der Abbildung angedeutet ist, mechanisch abgetastet. Als Gerät für diese Messung wurde ein konfokales Weißlichtmikroskop vom Typ "µ-Surf" des Herstellers Nanofocus verwendet. Das bei der Abtastung erhaltene Oberflächenprofil für A1 zeigt eine Vergrösserung der Oberflächenrauigkeit mit teilweisem Materialauftrag und teilweisem Schichtverschleiss von A1. Weniger Verschleiss kann man bei dem Oberflächenprofil von D2 beobachten: Auftrag an den Rändern der oszillierenden Bewegung und fast kein Abtrag in der Mitte, wenn man von einem Kratzer absieht. Auf der Skala des Verschleisses (1-kein Verschleiss, 5-starker Verschleiss) würden diese Verschleisse mit etwa 2 für A1 und 1-2 für D2 bewertet.

Dem Fachmann auf tribologischem Gebiet ist auch die Grösse des Reibungskoeffizienten erklärbar. Die Werte um 0.8 sind typisch für eine trockene Reibung von Stahl auf Stahl, was in diesem Falle durch den Materialübertrag auf die Schicht realisiert wird. Weitere Verschleisswerte sind in der Tabelle 2 angegeben. Bei den Werten für B1 und C2 wurde noch ein Minuszeichen hinter dem Verschleisswert gesetzt, welches andeuten soll, dass bei diesen beiden Schichten ein sehr starker Materialübertrag des Gegenkörpers stattfand, also es nicht zu Verschleiss sondern zu Schichtaufbau mit dem Gegenkörpermaterial kam. Die Werte in der Tabelle weisen daraufhin, dass mit Ausnahme von C1 die Schichten hohe Verschleissfestigkeit gegenüber Stahl aufweisen. Sie deuten aber darauf hin, dass trockene Bedingungen für die diskutierten Schichten vermieden werden müssen, wenn man im tribologischen System eine gegen Stahl verschleissfeste Schicht mit Stahl als Gegenkörper kombiniert. Unter diesen Bedingungen kann offenbar auch eine verbesserte Oberflächenrauigkeit das Aufschmieren des Gegenkörpermaterials nicht verhindern.

Neben dem Verschleiss des beschichteten Körpers ist in einem tribologischen System natürlich auch der Verschleiss des Gegenkörpers von Bedeutung, wenn es um eine Optimierung des Verschleissverhaltens des Tribosystems geht. In Figur 5 wurde deshalb der Verschleiss des Gegenkörpers, in diesem Falle der polierten Kugel aus 100Cr6 Stahl untersucht, indem lichtmikroskopische Bilder von dem Bereich der Kugel angefertigt wurden, der im Kontakt mit der Schicht war. Der Durchmesser der sog. Verschleisskappe ist ein Maß für den Verschleiss und man kann daraus noch das Verschleissvolumen berechnen. Für die tabellarische Auswertung wird hier wieder eine Skala von 1 bis 5 benutzt, wobei 1 wiederum keinen Verschleiss und 5 sehr grossen Verschleiss bedeutet. Für die in Figur 5 dargestellten Fotos wird A1 mit 4 und D2 mit 3 bewertet.

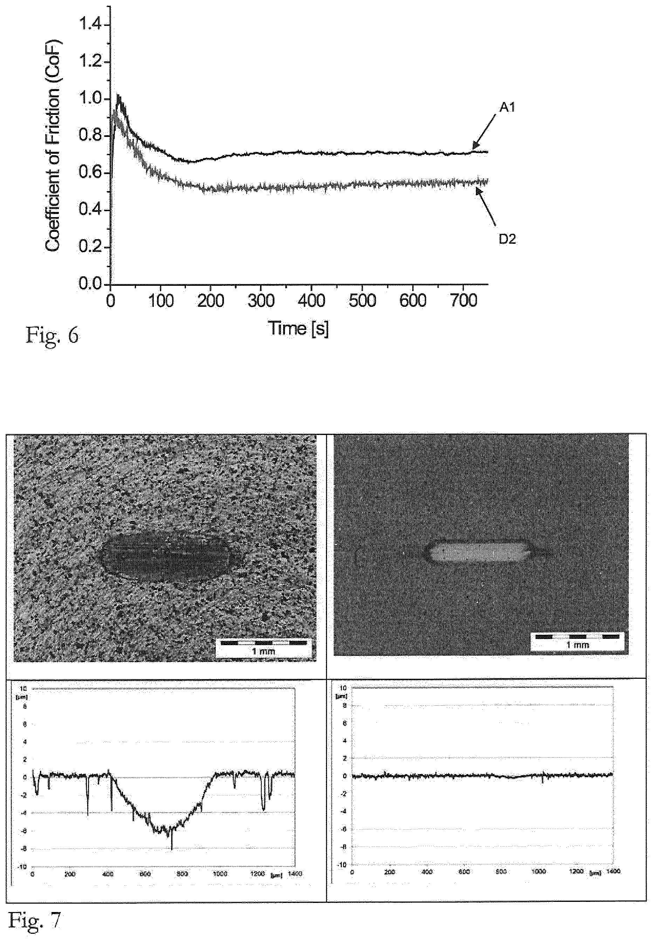

Was weiter auffällt, ist das geringere Rauschen im zeitlichen Verlauf des Reibungskoeffizienten für D2. Die Untersuchung des Schichtverschleisses anhand der lichtmikroskopischen Bilder und Oberflächenprofile im Verschleissbereich ergibt unterschiedliche Resultate für die beiden Schichten (Figur 7). Ein deutlicher Schichtverschleiss wird bei A1 beobachtet, der mit 4 abgeschätzt wird. Erstaunlicherweise keinen Schichtverschleiss findet man bei D2. Es findet lediglich eine Art Glättung des Kontaktbereiches statt. Basierend darauf wird der Schichtverschleiss mit 1 bewertet.

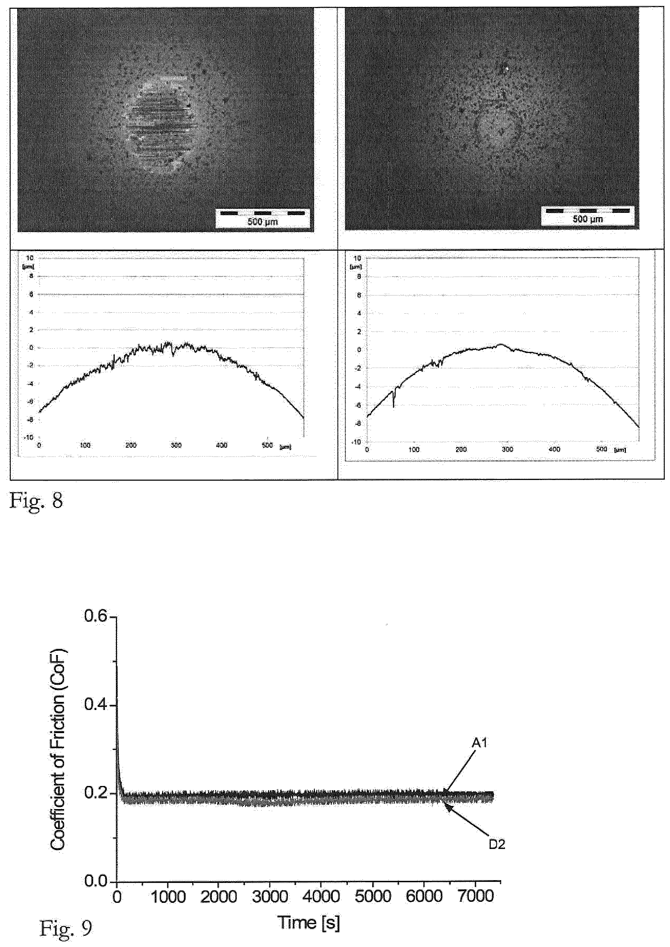

Der Verschleiss des Aluminiumoxydgegenkörpers ist in Figur 8 dargestellt. Der Verschleiss des Gegenkörpers ist für beide Schichtsysteme eindeutig kleiner, als es beim 100Cr6 Gegenkörper der Fall ist. Für A1 (oben links) zeigt der Gegenkörper eine Kontaktfläche, die viele Kratzer aufweist. Nachmessungen der Rundung des Gegenkörpers (unten links) bestätigen eine Aufrauhung der Oberfläche des Aluminiumoxyd Gegenkörpers, obwohl ansonsten keine wesentliche Veränderung des Kugelradius zu beobachten war. Man kann vermuten, dass bei dieser Materialpaarung Ausbrüche generiert werden, die zu einer solch raueren Oberfläche führen. Die Hintergründe dieser Ausbrüche konnten bisher noch nicht zweifelsfrei abgeklärt werden. Für D2 beobachtet man keinen Verschleiss des Gegenkörpers (rechte Spalte). Das ist ein erstaunliches Ergebnis für ein tribologisches System ohne Schmierung, das unter hohem Kontaktdruck betrieben wird. Die Kreisfläche in den Fotos mit modifizierter Oberflächengüte für A1 und D2 zeigt den Bereich der Deformation an, wenn der Test unter den gewählten Bedingungen abläuft und charakterisiert lediglich die Verformung im Bereich im Kontaktbereich von Körper und Gegenkörper, die eben typisch ist für die jeweilige Materialpaarung. Diese Deformation ist also nicht notwendigerweise eine Verschleisskappe wie das für die 100Cr6 Kugel der Fall war. Den Beweis dafür liefert wiederum die Abtastung der Oberfläche mit dem Nanofokus, die den ursprünglichen Radius liefert und keine Abplattung der Kugel zeigt. Die herausragenden Ergebnisse für den trockenen SRV-Test liefern also die Körper und Gegenkörper bei denen Schichtpaarungen von Chrom- und Aluminiumchromoxyd-basierenden Schichten vorliegen.

Im Folgenden werden die Ergebnisse vorgestellt, die sich im SRV-Test mit Schmiermittel ergaben. Die Tests wurden mit verschiedenen Schmiermitteln durchgeführt. Diese führten zu unterschiedlichen Reibungskoeffizienten. Im Verschleiss sind diese Unterschiede aber weniger oder nicht differenzierbar. Meist zeigt sich lediglich eine andere Einfärbung des Kontaktbereichs. Untersuchungen ergaben, dass dies vor allem auf die unterschiedlichen Additive im Öl zurückzuführen ist. Da die Behandlung der Additive nicht Gegenstand dieser Erfindung ist, wird auf diese Unterschiede nicht näher eingegangen.

In Figur 9 ist der zeitliche Verlauf des Reibungskoeffizienten für A1 (1) und D2 (2) dargestellt, der mit Dieselöl als Schmiermittel (hier bezeichnet als Öl1) und der Stahlkugel als Gegenkörper gemessen wurde. Für A1 ergibt sich im eingelaufenen Betrieb ein Reibungskoeffizient von 0.20, während der von D2 bei 0.18 liegt. Die relativen Unterschiede in den Reibungskoeffizienten beim Vergleich mit dem trockenen Test sind kleiner geworden, d.h. der Materialeinfluss unter geschmierten Bedingungen ist weniger ausgeprägt. Grösseren Einfluss hat auch die Oberflächenbeschaffenheit der Beschichtung, d.h. dass die Loch- oder Porenstruktur einer Oberfläche - wie sie bei A1 als Folge des thermischen Spritzprozesses vorliegt - geeigneter ist, das Schmiermittel in der Oberfläche zu halten und damit vor allem bei Mangelschmierung das tribologische System sicherer macht. Andeutungsweise kann man das auch beim Vergleich von C2 und D2 sehen, da die nicht polierte Schicht C2 einen geringeren Reibungskoeffizient aufweist als die polierte. Die Tabelle 3 stellt alle Reibungskoeffizienten für den geschmierten SRV-Test mit dem Stahl als Gegenkörper zusammen.

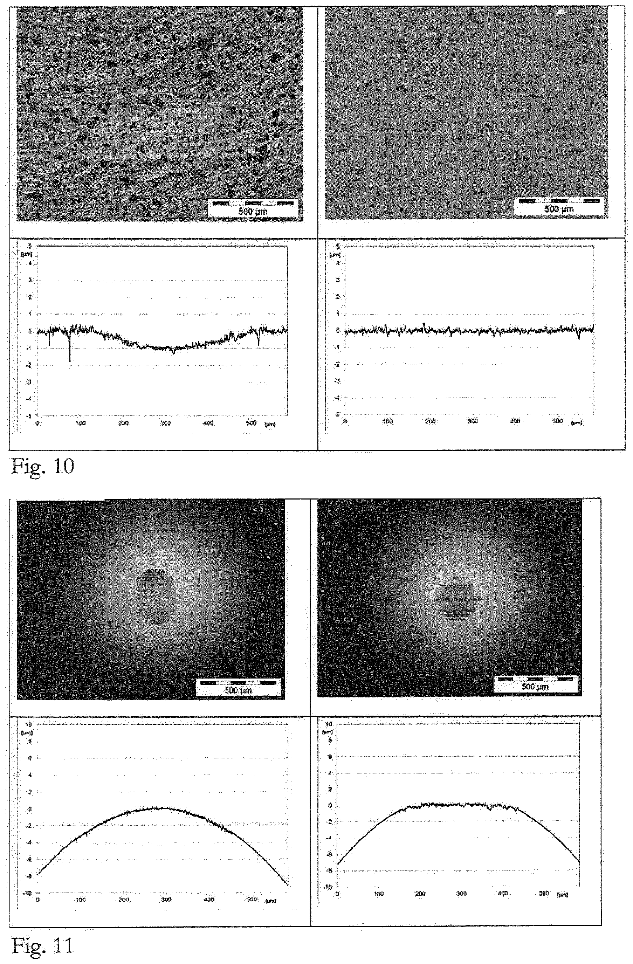

Der Schichtverschleiss, der unter diesen Testbedingungen erhalten wurde, ist in Figur 10 dargestellt. A1 zeigt mit dem Wert 2 geringen Schichtverschleiss und ansonsten nur einen Glättungseffekt im Kontaktbereich. Für D2 kann kein Schichtverschleiss (Wert 1) gemessen werden. Auch hier könnte eine Glättung stattfinden, obwohl diese nicht deutlich im gemessenen Oberflächenprofil nachweisbar ist. Die übrigen Werte für den Schichtverschleiss sind wiederum in Tabelle 3 angegeben. Geringer Verschleiss kann nur für die Schichten A1, B1 und C1 gemessen werden, während alle Chromund Aluminiumchromoxyd-basierenden Schichten keinen Verschleiss zeigen.

Der Verschleiss des Gegenkörpers aus Stahl mit dem Schmiermittel Öl1 ist in Figur 11 dargestellt. Für beide Konfigurationen sieht man Oberflächenverfärbungen. Das Oberflächenprofil der 100Cr6 Kugel im Falle von A1 zeigt wenig Verschleiss (Wert 1-2), d.h. dass die Oberflächenverfärbung allein durch eine elastische Deformation der Kontaktfläche zustande kommt und die Verfärbung durch einen dünnen Film entstanden ist, der vor allem durch die Additive im Öl oder dessen Zersetzungsprodukte entstanden ist Für D2 ist die Grösse der Kontaktflächenverfärbung ähnlich der von A1, aber anhand des Oberflächenprofils der 100Cr6 Kugel kann man geringen Verschleiss mit dem Wert 2 feststellen. Deutlicheren Verschleiss erfährt der Stahlkörper durch die Schichten E1 und C2. Alle Chrom- und Aluminiumchromoxyd-basierenden Schichten zeigen eine sehr hohe Mikrohärte von über 20 GPa (gemessen nach der Norm ISO 14577), und es ist wichtig, dass die Oberflächengüte entsprechend gewählt wird, falls man diese Schichten mit Stahl als Gegenkörper einsetzen möchte.

Von grossem Interesse ist das Ergebnis des SRV-Tests mit dem Aluminiumoxydgegenkörper, weil bereits unter trockenen Bedingungen auf beiden Tribopartnern für D2 kein Verschleiss festgestellt werden konnte. Figur 10 zeigt wiederum den zeitlichen Verlauf des Reibungskoeffizienten, für den sich zu Ende des Tests für A1 ein Wert von 0.19 und für D2 ein Wert von 0.18 ergibt. Auch hier ist der relative Einfluss des Schichtmaterials auf den Reibungskoeffizienten geringer als im trockenen Test. Offensichtlich spielt die Formierung einer Oberfläche, die sich aus dem Zusammenspiel von Materialoberfläche, Öl und Additiven ergibt und die sich in der Verfärbung manifestiert, eine wichtigere Rolle. B1 besitzt den höchsten Reibungskoeffizienten. Ansonsten wurde für alle anderen Materialien ein Reibungskoeffizient von 0.18 gemessen. Im Rahmen dieser Tests ist der Reibungskoeffizient erstaunlicherweise kleiner als bei bereits eingeführten Schichten A1 und C1 gegen Stahl.

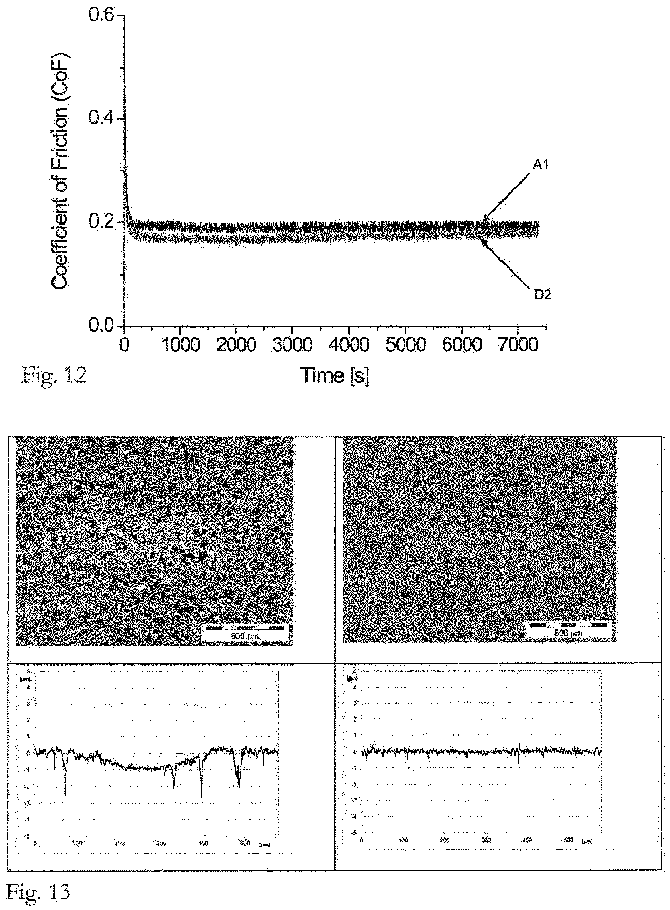

Figur 13 zeigt den Schichtverschleiss, der sehr gering ist für A1 (Wert 2) und eher nur auf einen Glättungseffekt hindeutet. Das ist ein gutes Verhalten, vor allem vor dem Hintergrund, dass die Schicht sehr viele (Poren) enthält. Dies weist wiederum darauf hin, dass eine solche Oberflächengeometrie zu besseren tribologischen Eigenschaften beiträgt, d.h. dass Schmiermittel in den Schichtvertiefungen zurückgehalten werden und die Reibungsverluste verringern. Für D2 lässt sich kein Schichtverschleiss messen (Wert 1). Die Schicht ist stabil, obwohl auch hier ein gewisser Glättungseffekt vermutet wird. Grossen Verschleiss zeigt B1 (Wert 5) und auch C1 (Wert 4). Vor allem die Schicht B1 zeigt, wie wichtig es ist, Körper und Gegenkörper aufeinander abzustimmen, denn B1 liefert den niedrigsten Reibungskoeffizienten gegen Stahl und den höchsten gegen Aluminiumoxyd.

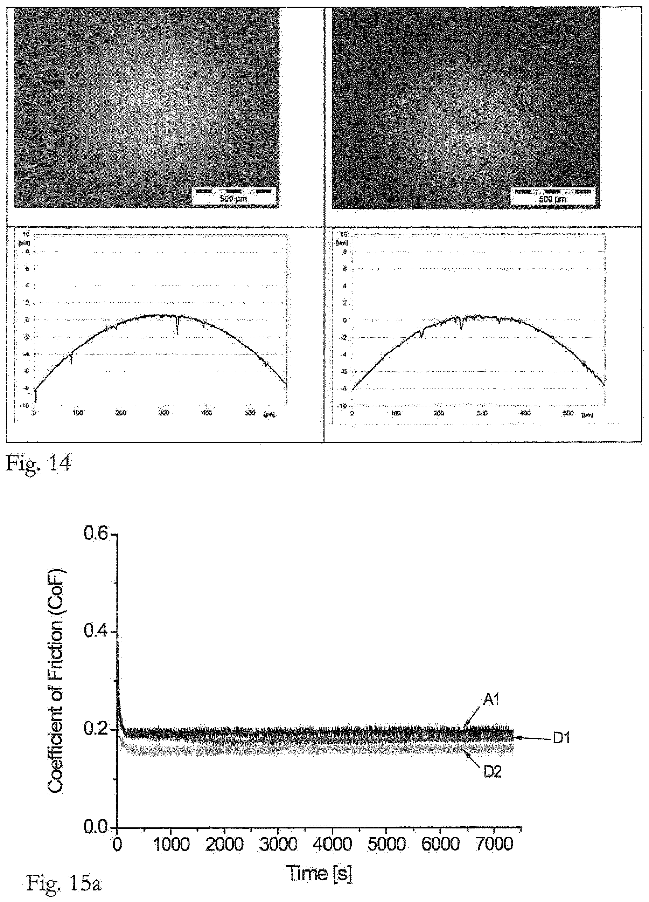

Figur 14 charakterisiert den Verschleiss des Aluminiumoxydgegenkörpers. Sowohl für A1 wie auch für D2 kann man keinen Verschleiss der Kugel feststellen (beide Werte 1). Die Rauigkeit im Oberflächenbereich, die im Oberflächenprofil gemessen wird, ist charakteristisch für die gegebene Porosität des Materials. Die Kratzer sind auf kleine Ausbrüche des Materials zurückzuführen, die bei dem Test zwischen die Oberflächen von Schicht und Gegenkörper gelangen und bei unserem Testaufbau, im Gegensatz zu realen Motorentests, nicht mit dem Öl wegtransportiert werden.

Die Tabellen 2 und 3 fassen die Ergebnisse für die getesteten Schichtmaterialien bezüglich der zwei Gegenkörpermaterialien für die verschiedenen Testbedingungen zusammen. Die qualitativen Einschätzungen wurden aus den Messungen abgeleitet, so wie es beispielhaft im vorhergehenden Text erklärt wurde. Auf der Basis dieser Untersuchungen lassen sich die bisherigen Ergebnisse des SRV-Tests folgendermaßen zusammenfassen:
SRV: trocken mit 100Cr6 als Gegenkörper
   - Für alle Tests kommt es zu einem beträchtlichen Verschleiss des 100Cr6 Stahlgegenkörpers
   - Die Tests stabilisieren sich bei Reibungskoeffizienten im Bereich um 0.8. Das ist darauf zurückzuführen, dass Material des Gegenkörpers auf die jeweilige Schicht aufgeschmiert (übertragen) wird und dadurch ein Stahl-Stahl-Kontakt entsteht. Dementsprechend wird für alle hier untersuchten Schichten ein deutlicher und hoher Gegenkörperverschleiss beobachtet.
SRV: trocken mit Aluminiumoxyd als Gegenkörper
   - Die Schichten A1, B1 und C1 zeigen Schichtverschleiss, obwohl dieser bei den hier ausgewählten Schichten im Vergleich zu anderen gängigen Materialien, die nicht in die Tabelle aufgenommen wurden, geringer ist.
   - Die untersuchten oxydischen Schichten unterteilen sich in zwei Gruppen. Die Gruppe mit hoher Oberflächenrauigkeit (E1) besitzt einen Reibungskoeffizienten um 0.8 und zeigt starkes Rauschen im zeitlichen Verlauf des Reibungskoeffizienten. Die zweite Gruppe (D1, C2, D2) besitzt Reibungskoeffizienten um 0.6 und hebt sich damit von den übrigen Schichten deutlich ab. Die Schichten dieser Gruppe besitzen eine Oberflächenrauigkeit von Ra unter 0.4 µm.
   - Keinen Schichtverschleiss, abgesehen von Glättungseffekten, zeigen alle Oxydschichten auf Cr und Al-Cr-Basis (D1, C2, D2).
SRV: geschmiert mit 100Cr6 als Gegenkörper
   - Die Reibungskoeffizienten für alle untersuchten Schichten zeigen Werte unter 0.2, wobei B1 und D1 am niedrigsten sind.
   - Die nicht Chrom- und Aluminiumchromoxyd-basierenden Schichten (A1, B1, C1) zeigen geringen Verschleiss vom Wert 2.
   - Kein Schichtverschleiss kann bei den Chrom- und Aluminiumchromoxyd-basierenden Schichten (D1, C2, D2) festgestellt werden.
   - Mit Ausnahme von E1 und C2, d.h. den harten oxydischen Schichten mit grösserer Oberflächenrauigkeit, ergibt sich für alle anderen Schichtmaterialien kleiner Gegenkörperverschleiss vom Wert 1-2 oder 2. Die Oberflächenrauigkeit der Schicht unter geschmierten Bedingungen und mit 100Cr6 als Gegenkörper spielt offensichtlich eine wichtige Rolle, und falls man solche Materialpaarungen realisieren möchte, muss das Einlaufverhalten optimiert und die Schichtrauigkeit Ra kleiner als 0.2µm sein.
SRV: geschmiert mit Aluminiumoxyd als Gegenkörper
   - Die Reibungskoeffizienten liegen bis auf B1 (0.21) alle im Bereich zwischen 0.18 und 0.20.
   - Der Schichtverschleiss ist sehr gross bei B1, mittel bei C1 und E1 und gering bei A1. Keinen Schichtverschleiss kann man bei Chrom- und Aluminiumchromoxyd-basierenden Schichten D1, C2 und D2 feststellen.
   - Der Test generiert wenig Verschleiss des Gegenkörpers für die meisten Schichten, aber keinen Verschleiss für A1, D1 und D2.

Abschließend wurde der Test auch noch bei höheren Temperaturen durchgeführt. Dafür wurde ein anderes, etwas temperaturstabileres Öl2 verwendet. Die Verwendung dieses Öls änderte prinzipiell nichts an den bisher gewonnenen Erkenntnissen, die der vorhergehende SRV Test bei RT ergab. Das Öl2 lieferte geringfügig andere Reibungskoeffizienten, ergab aber qualitativ keine anderen Ergebnisse für das Verschleissverhalten von Schicht und Gegenkörper.

Das soll nicht heißen, dass dies für alle anderen Öle ebenfalls so ist. Allein die Benutzung eines anderen Additivs kann zu drastischen Änderungen im Reibungskoeffizienten führen. Das war aber nicht der Inhalt dieser Untersuchungen und deshalb soll darauf nicht näher eingegangen werden. Das für die SRV Tests bei höheren Temperaturen benutzte Öl2 war stabil für Tests bis zu Temperaturen von 160°C.

In Tabelle 4 sind die getesteten Schichten angegeben, die bei Raumtemperatur (RT), 100°C und 160°C getestet wurden. Die Tabelle gibt nur eine kleine Auswahl der getesteten Schichten wieder und konzentriert sich im Wesentlichen auf die Schichtmaterialien, die Gegenstand der Erfindung sind.

Wieder wurde für diese Schichten und die Gegenkörper, wie oben schon beschrieben, der zeitliche Verlauf des Reibungskoeffizienten, der Schichtverschleiss und der Verschleiss des Gegenkörpers untersucht. Im Folgenden soll diese Vorgehensweise wieder an einem Beispiel demonstriert werden, wobei diesmal auf die lichtmikroskopischen Aufnahmen verzichtet wurde und nur die Oberflächenprofile gezeigt werden. Die Ermittlung der Reibungskoeffizienten sowie die qualitative Einschätzung des Schicht- und Gegenkörperverschleisses wurden analog zu den bereits oben beschriebenen Auswertungen durchgeführt.

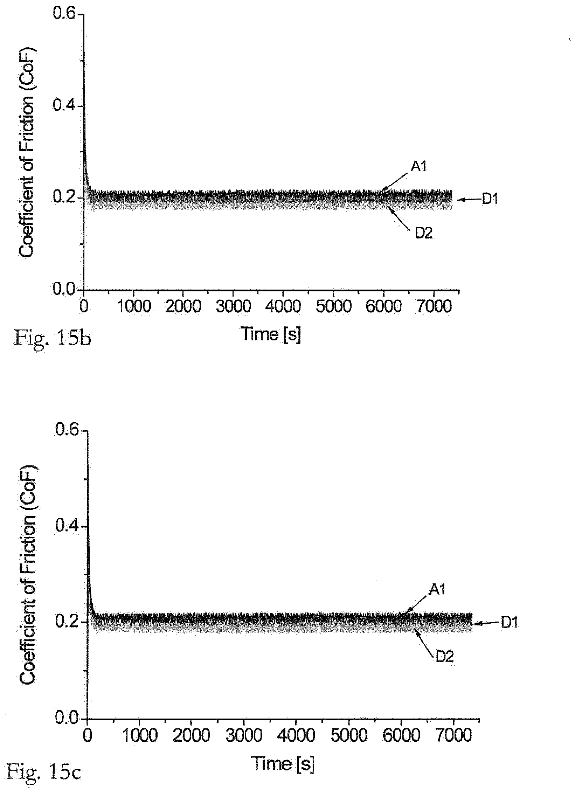

In Figur 15a bis c sind die zeitlichen Verläufe des Reibungskoeffizienten für die Schichtsysteme A1, D1. und D2 mit dem Aluminiumoxyd als Gegenkörper und für den geschmierten (Öl2) SRV-Test dargestellt. Vergleicht man die verschiedenen Schichtmaterialien bei Raumtemperatur, so kann man deutliche Unterschiede zwischen A1 und D1 sowie D2 ausmachen. Diese werden mit höheren Temperaturen geringer, verschwinden jedoch nicht. Für alle Temperaturen besitzen die Schichten D1 und D2 die kleinsten Reibungskoeffizienten.

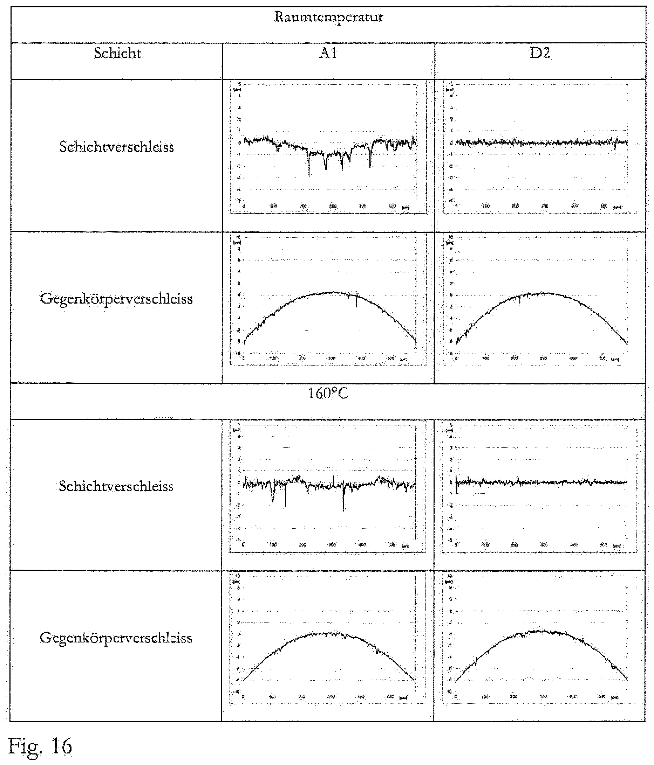

In Figur 16 werden der Schichtverschleiss und der Gegenkörperverschleiss für die Schichten A1 und D2 gegenübergestellt. Während A1 geringen Schichtverschleiss vom Wert 2 aufweist, zeigt D2 keinen Schichtverschleiss. Zudem gibt es keinen Verschleiss des Aluminiumoxydgegenkörpers für beide Schichten.

Zusammenfassend kann man für die SRV-Tests bei höheren Temperaturen folgendes sagen:
SRV: geschmiert mit 100Cr6 als Gegenkörper bei höheren Temperaturen
   - Die Reibungskoeffizienten für alle untersuchten Schichten zeigen Werte um 0.2. Bei RT besitzen die Schichten D1 und D2 mit etwa 0.18 bzw. 0.16 einen deutlich niedrigeren Wert als A1 (0.20). Bei höheren Temperaturen verschwinden diese Unterschiede zunehmend, obwohl die auf den Chrom- und Aluminiumchromoxyd-basierenden Schichten immer noch die niedrigsten Reibungskoeffizienten aufweisen.
   - A1 zeigt geringen Schichtverschleiss für alle Temperaturbereiche, wohingegen die oxydischen Schichten D1 und D2 keinen Schichtverschleiss zeigen. Dagegen tritt bei vielen nichtoxydischen Schichten Verschleiss auf.
      Mit Ausnahme von B1 und C2 kommt es nur zu geringem Gegenkörperverschleiss. Hier spielt die Oberflächenrauigkeit der Schicht eine wichtige Rolle und wohl auch das Einlaufverhalten des Tribosystems. Der Gegenkörperverschleiss stabilisiert sich nach einer gewissen Zeit über die Grösse der Kontaktfläche.
SRV: geschmiert mit Aluminiumoxyd als Gegenkörper bei höheren Temperaturen
   - Die Reibungskoeffizienten sind bei RT etwas niedriger und zeigen einen geringen Anstieg für die höheren Temperaturen. Sie liegen aber in allen Fällen um 0.2, wobei die Chrom- und Aluminiumchromoxyd-basierenden Schichten D1 und D2 niedriger sind als A1.
   - Geringer Schichtverschleiss tritt bei A1 bei allen Temperaturen auf, grösserer Verschleiss bei B1. Die Chrom- und Aluminiumchromoxyd-basierenden Schichten haben keinen Verschleiss.
   - Für alle Schichten kann man keinen Verschleiss des Gegenkörpers messen.

Es wurde ein tribologisches System 1 oder 2 mit Körper 105, 107 und Gegenkörper 103, 111, die zusammen einen tribologischen Kontakt formieren, beschrieben, wobei die Oberfläche 108 vom Körper 105, 107 zumindest im Bereich des Kontaktes mit einer ersten Beschichtung 12 beschichtet ist und die Oberfläche 112 vom Gegenkörper 103, 111 zumindest im Bereich des Kontaktes mit einer zweiten Beschichtung 11 beschichtet ist, gekennzeichnet dadurch, dass zumindest eine der ersten und zweiten Beschichtung 12, 11 eine Chromoxyd- oder Aluminiumchromoxyd-basierende Schicht ist.

Beim tribologisches System 1 oder 2 kann die andere Schicht 11, 12 eine Mo-, MoN-, MoCuN-, DLC- oder ta-C basierte Schicht umfassen.

Beim tribologischen System 1 oder 2 kann sowohl die erste als auch die zweite Beschichtung 12, 11 Chromoxyd- oder Aluminiumchromoxyd-basierende Schichten umfassen.

Es kann zumindest eine der Beschichtungen 12, 11 und vorzugsweise beide Beschichtungen 12, 11 eine chemische Zusammensetzung von (Al1-xCr-y)2O3 aufweisen, wobei 0.1 ≤ x ≤ 1 und y ≤ 0.5 ist.

Zumindest eine dieser Beschichtungen 12, 11 und vorzugsweise beide Beschichtungen 12, 11 können eine Härte von 18 GPa oder grösser aufweisen.

Das tribologische System kann Teil eines Verbrennungsmotors 100 sein, wobei der Verbrennungsmotor vorzugsweise zur Verbrennung von Benzin, Diesel oder Gas ausgestaltet ist

Der Körper kann beispielsweise ein Kolbenring 103 und der Gegenkörper beispielsweise eine Zylinderlaufbahn 108 sein. Vorzugsweise sind noch weitere Oberflächen des Verbrennungsmotors 100 mit den Chromoxyd- oder Aluminiumchromoxyd-basierenden Schichten beschichtet, besonders bevorzugt Zylinderringnuten 104, das Kolbenhemd (Kolbenstutzen 111), Kolbenstutzenlaufbahn 113 und/oder Kolbenboden 109.

**Tabelle 1a: Schichten, die mit dem thermischen Spritzverfahren hergestellt wurden und vorwiegend für die Beschichtung der Zylinderlaufbahn gedacht sind. Die Schichten A1, B1, C1 und D1 sind nicht erfindungsgemäß.**

| Benennung der Beschichtung | Pulvermaterial | Chemische Zusammensetzung der Beschichtung | Oberflächenrauigkeit Ra [µm] |
|---|---|---|---|
| A1 | Fe-Basis | Fe(bal.)-C(1.2Gew.-%)-Mn(1.4Gew.-%)-Cr(1.4Gew.-%) | 0.5 |
| B1 | Titan-Oxyd | TiO2 | 0.25 |
| C1 | Ni-Basis | Ni(bal.)-CrWMoCuCB | 0.33 |
| D1 | Chrom-Oxyd | Cr2O3 | 0.15 |
| E1 | Aluminum-Chrom-Oxyd | (Al2O3(62Gew.-%)-Cr2O3(38Gew.-%) | 0.45 |

**Tabelle 1b: Schichten, die mit kathodischer Funkenverdampfung hergestellt wurden und vorwiegend für die Beschichtung der Kolbenringe gedacht sind.**

| Benennung der Beschichtung | Beschichtung | Chemische Zusammensetzung der Beschichtung | Oberflächenrauigkeit Ra [µm] |
|---|---|---|---|
| C2 | Aluminium-Chrom-Oxyd | Al-Cr-O Beispiel: (Al0.7Cr0.3)2O3 | Unpoliert 0.4 |
| D2 | Aluminium-Chrom-Oxyd | Al-Cr-O Beispiel: (Al0.7Cr0.3)2O3 | Poliert 0.15 |

**Tabelle 2: Beschreibung der Ergebnisse, die der SRV Test unter trockenen Bedingungen mit den Gegenkörpern aus 100Cr6 und Aluminiumoxyd lieferte Die Schichten A1, B1, C1 und D1 sind nicht erfindungsgemäß.**

| Benennung der Beschichtung | Reibungskoeffizient | | Schichtverschleiss | | Gegenkörperverschleiss | |
|---|---|---|---|---|---|---|
| | 100Cr6 | Aluminiumoxyd | 100Cr6 | Aluminiumoxyd | 100Cr6 | Aluminiumoxyd |
| | | | | | | |
| A1 | 0.86 | 0.73 | 2 | 4 | 4 | 1 |
| B1 | 0.82 | 1.04 | 1(-) | 5 | 4 | 1 |
| C1 | 0.79 | 0.74 | 4 | 4 | 3-4 | 1 |
| D1 | 0.66 | 0.66 | 1 | 1 | 4 | 1 |
| E1 | 0.78 | 0.78 | 1 | 5 | 4 | 1 |
| C2 | 0.76 | 0.56 | 1(-) | 1 | 4 | 1 |
| D2 | 0.76 | 0.56 | 1-2 | 1 | 3 | 1 |

**Tabelle 3: Beschreibung der Ergebnisse, die der SRV Test unter geschmierten Bedingungen (Schmiermittel Öl1) mit den Gegenkörpern aus 100Cr6 und Aluminiumoxyd lieferte Die Schichten A1, B1, C1 und D1 sind nicht erfindungsgemäß.**

| Benennung der Beschichtung | Reibungskoeffizient | | Schichtverschleiss | | Gegenkörperverschleiss | |
|---|---|---|---|---|---|---|
| | 100Cr6 | Aluminiumoxyd | 100Cr6 | Aluminium-oxyd | 100Cr6 | Aluminiumoxyd |
| | | | | | | |
| A1 | 0.20 | 0.19 | 2 | 2 | 1-2 | 1 |
| B1 | 0.16 | 0.21 | 2 | 5 | 2 | 1-2 |
| C1 | 0.20 | 0.18 | 2 | 4 | 2 | 1-2 |
| D1 | 0.16 | 0.18 | 1 | 1 | 2 | 1 |
| E1 | 0.18 | 0.18 | 1 | 3 | 3 | 2 |
| C2 | 0.17 | 0.18 | 1 | 1 | 4 | 2 |
| D2 | 0.18 | 0.18 | 1 | 1 | 2 | 1 |

**Tabelle 4: Beschreibung der Ergebnisse, die der SRV Test unter geschmierten Bedingungen (Schmiermittel Öl2) mit den Gegenkörpern aus 100Cr6 und Aluminiumoxyd lieferte als Funktion der Temperatur Die Schichten A1, B1 und D1 sind nicht erfindungsgemäß.**

| RT | Reibungskoeffizient | | Schichtverschleiss | | Gegenkörperverschleiss | |
|---|---|---|---|---|---|---|
| Benennung der Beschichtung | 100Cr6 | Aluminiumoxyd | 100Cr6 | Aluminiumoxyd | 100Cr6 | Aluminium-oxyd |
| A1 | 0.21 | 0.20 | 2 | 2 | 2 | 1 |
| B1 | 0.20 | 0.19 | 4 | 3-4 | 3 | 2 |
| D1 | 0.18 | 0.18 | 2 | 2 | 2 | 1 |
| C2 | 0.18 | 0.20 | 1 | 1-2 | 3-4 | 1 |
| D2 | 0.16 | 0.16 | 1 | 1 | 1-2 | 1 |
| | | | | | | |

| 100°C | Reibungskoeffizient | | Schichtverschleiss | | Gegenkörperverschleiss | |
|---|---|---|---|---|---|---|
| Benennung der Beschichtung | 100Cr6 | Aluminiumoxyd | 100Cr6 | Aluminiumoxyd | 100Cr6 | Aluminium-oxyd |
| A1 | 0.21 | 0.21 | 2 | 2 | 2 | 1 |
| B1 | 0.22 | 0.21 | 3 | 3 | 2 | 1 |
| D1 | 0.19 | 0.20 | 1 | 1 | 1-2 | 1 |
| C2 | 0.19 | 0.19 | 1 | 1 | 3 | 1 |
| D2 | 0.18 | 0.18 | 1 | 1 | 1-2 | 1 |

| 160°C | Reibungskoeffizient | | Schichtvers chleis s | | Gegenkörperverschleiss | |
|---|---|---|---|---|---|---|
| Benennung der Beschichtung | 100Cr6 | Aluminiumoxyd | 100Cr6 | Aluminiumoxyd | 100Cr6 | Aluminiumoxyd |
| A1 | 0.21 | 0.21 | 2 | 2 | 2 | 1 |
| B1 | 0.21 | 0.21 | 3 | 3 | 2 | 1 |
| D1 | 0.20 | 0.20 | 1 | 1 | 2 | 1 |
| C2 | 0.20 | 0.20 | 1 | 1 | 3 | 1 |
| D2 | 0.19 | 0.19 | 1 | 1 | 1-2 | 1 |

## Patentansprüche

1. Tribologisches System (1; 2) mit einem ersten Körper (102; 105) und einem zweiten Körper (101; 107), die jeweils eine Komponente eines Verbrennungsmotors (100) bilden, insbesondere Kolben (102), Kolbenring (105) oder Zylinder (101,107), und deren Oberflächen (112, 108, 113) einen ersten und zweiten Stoffbereich (11, 12) aufweisen, die sich im Betrieb wenigstens bereichsweise berühren und einen tribologischen Kontakt bilden, wobei
der erste Stoffbereich (11) an einem als Kolbenring (103) ausgebildeten ersten Körper eine Aluminiumchromoxyd-basierende Schicht mit einer chemischen Zusammensetzung von (Al1-xCr y) 203 ist, wobei gilt: 0,1 ≤ x ≤ 1 und y ≤ 0,5; 0,5 ≤ x ≤ 1 und y ≤ 0,5 oder x = 0,7 und y = 0,3 und der zweite Stoffbereich (12) an einem als Zylinder (101, 107) ausgebildeten zweiten Körper eine Aluminium-Chromoxid-Mischschicht mit einer Zusammensetzung von 10 Gew.-% bis unter 100 Gew.-% Cr2O3 und entsprechend mehr als 0 Gew.-% bis 90 Gew.-% Al2O3 ist.

2. Tribologisches System (1; 2) nach Anspruch 1, wobei der erste und zweite Stoffbereich (11, 12) jeweils an einer eine Lauffläche bildenden Oberfläche der Komponenten (101, 107, 105, 102) angeordnet sind, insbesondere an einer Kolbenschaftlaufbahn (113), einer Ringlauffläche (112) und/oder einer Zylinderlaufbahn (108).

3. Tribologisches System (1; 2) nach einem der Ansprüche 1 oder 2, wobei der erste Stoffbereich (11) eine Oberflächenrauigkeit Ra in µm aufweist, für die gilt: 0,1 ≤ Ra ≤ 0,5; 0,15 ≤ Ra ≤ 0,4; Ra = 0,15 oder Ra = 0,4 und der zweite Stoffbereich eine Oberflächenrauigkeit aufweist, für die gilt: Ra = 0,45.

4. Tribologisches System (1; 2) nach einem der Ansprüche 1 bis 3, wobei einer der Stoffbereiche (11, 12) mittels eines thermischen Spritzverfahrens ausgebildet ist.

5. Tribologisches System (1; 2) nach Anspruch 4, wobei der mittels eines thermischen Spritzverfahrens ausgebildete Stoffbereich (11, 12) eine Schichtdicke zwischen 150 µm und 800 µm aufweist.

6. Tribologisches System (1; 2) nach einem der Ansprüche 1 bis 5, wobei einer der Stoffbereiche (11, 12) mittels eines PVD-Verfahrens, insbesondere kathodische Funkenverdampfung, ausgebildet ist.

7. Tribologisches System (1; 2) nach Anspruch 6, wobei der mittels eines PVD-Verfahrens ausgebildete Stoffbereich eine Schichtdicke zwischen 10 µm und 30 µm aufweist.

8. Tribologisches System (1; 2) nach einem der Ansprüche 1 bis 7, wobei wenigstens eine der Schichten eine Härte von wenigstens 18 GPa aufweist.

9. Verbrennungsmotor (100) mit einem tribologischen System (1; 2) nach einem der Ansprüche 1 bis 8.

10. Verbrennungsmotor (100) nach Anspruch 9, wobei der Kolben (102) wenigstens einen weiteren Oberflächenbereich aufweist, insbesondere in Kolbenringnutbereichen (104, 110), am Kolbenboden (109), und/oder am Kolbenschaft (111), der als eine Chromoxyd- oder Aluminiumchromoxyd-basierende Schicht ausgebildet ist.

## Claims

1. A tribological system (1; 2) comprising a first body (102; 105) and a second body (101; 107), which each form a component of an internal combustion engine (100), in particular a piston (102), a piston ring (105) or a cylinder (101, 107) and the surfaces (112, 108, 113) of which have a first and second material area (11, 12), which come into contact with each other at least in some regions during operation and form a tribological contact, wherein
the first material area (11) on a first body formed as a piston ring (103) is a layer on the basis of aluminum chromium oxide, which has a chemical composition of (Al1-xCr-y)2O3, in which: 0.1 ≤ x ≤ 1 and y ≤ 0.5; 0.5 ≤ x ≤ 1 and y ≤ 0.5 or x = 0.7 and y = 0.3, and
the second material area (12) on a second body formed as a cylinder (101, 107) is an aluminum chromium oxide mixed layer having a composition of 10 wt.% to below 100 wt.% Cr2O3 and correspondingly more than 0 wt.% to 90 wt.% Al2O3.

2. The tribological system (1; 2) according to claim 1, wherein the first and second material area (11, 12) are each arranged on a surface of the components (101, 107, 105, 102) forming a running surface, in particular on a piston shaft slide way (113), a ring running surface (112) and/or a cylinder slide way (108).

3. The tribological system (1; 2) according to any of claims 1 or 2, wherein the first material area (11) has a surface roughness Ra in µm, to which applies: 0.1 ≤ Ra ≤ 0.5; 0.15 ≤ Ra ≤ 0.4; Ra = 0.15 or Ra = 0.4 and the second material area has a surface roughness to which applies Ra = 0.45.

4. The tribological system (1; 2) according to any of claims 1 to 3, wherein one of the material areas (11, 12) is formed by a thermal spraying method.

5. The tribological system (1; 2) according to claim 4, wherein the material area (11, 12) formed by a thermal spraying method has a layer thickness between 150 µm and 800 µm.

6. The tribological system (1; 2) according to any of claims 1 to 5, wherein one of the material areas (11, 12) is formed by a PVD method, in particular cathodic spark evaporation.

7. The tribological system (1; 2) according to claim 6, wherein the material area formed by a PVD method has a layer thickness between 10 µm and 30 µm.

8. The tribological system (1; 2) according to any of claims 1 to 7, wherein at least one of the layers has a hardness of at least 18 GPa.

9. An internal combustion engine (100) having a tribological system (1; 2) according to any of claims 1 to 8.

10. The internal combustion engine (100) according to claim 9, wherein the piston (102) has at least one further surface region, in particular in piston ring groove areas (104, 110), at the piston crown (109) and/or at the piston shaft (111), which is formed as a layer on the basis of chromium oxide or aluminum chromium oxide.

## Revendications

1. Système tribologique (1; 2) avec un premier corps (102; 105) et un second corps (101; 107), formant chacun un composant d'un moteur à combustion interne (100), en particulier un piston (102), un segment de piston (105) ou un cylindre (101, 107), et dont les surfaces (112, 108, 113) présentent une première et une seconde zone de matière (11, 12) qui, lors du fonctionnement, sont au moins localement en contact entre elles et forment un contact tribologique, où
la première zone de matière (11) sur un premier corps, conçu sous forme de segment de piston (103), est une couche à base d'oxyde de chrome et d'alumine ayant une composition chimique de (All-xCr-y)2O3, où : 0,1 ≤ x ≤ 1 et y ≤ 0,5; 0,5 ≤ x ≤ 1 et y ≤ 0,5 ou x = 0,7 et y = 0,3 et
la seconde zone de matière (12) sur un second corps, conçu sous forme de cylindre (101, 107), est une couche mixte d'oxyde de chrome et d'alumine ayant une composition de 10 % en poids à moins de 100 % en poids de Cr2O3 et, par conséquent, de plus de 0 % en poids à 90 % en poids d'Al2O3.

2. Système tribologique (1; 2) selon la revendication 1, dans lequel les première et seconde zones de matière (11, 12) sont disposées chacune sur une surface des composants (101, 107, 105, 102) formant une surface de roulement, en particulier sur une bande de roulement de tige de piston (113), une surface de roulement de segment (112) et/ou une surface de glissement de cylindre (108).

3. Système tribologique (1; 2) selon l'une quelconque des revendications 1 ou 2, dans lequel la première zone de matière (11) présente une rugosité de surface Ra en µm pour laquelle 0,1 ≤ Ra ≤ 0,5 ; 0,15 ≤ Ra ≤ 0,4 ; Ra = 0,15 ou Ra = 0,4, et la seconde zone de matière présente une rugosité de surface pour laquelle Ra = 0,45.

4. Système tribologique (1; 2) selon l'une quelconque des revendications 1 à 3, dans lequel une des zones de matière (11, 12) est formée par un procédé de pulvérisation thermique.

5. Système tribologique (1; 2) selon la revendication 4, dans lequel la zone de matière (11, 12) formée par un procédé de pulvérisation thermique présente une épaisseur de couche comprise entre 150 µm et 800 µm.

6. Système tribologique (1; 2) selon l'une quelconque des revendications 1 à 5, dans lequel l'une des zones de matière (11, 12) est formée par un procédé PVD, en particulier par évaporation cathodique par étincelle.

7. Système tribologique (1; 2) selon la revendication 6, dans lequel la zone de matière formée par un procédé PVD a une épaisseur de couche comprise entre 10 µm et 30 µm.

8. Système tribologique (1; 2) selon l'une quelconque des revendications 1 à 7, dans lequel au moins une des couches présente une dureté d'au moins 18 GPa.

9. Moteur à combustion interne (100) comprenant un système tribologique (1; 2) selon l'une des revendications 1 à 8.

10. Moteur à combustion interne (100) selon la revendication 9, dans lequel le piston (102) présente au moins une autre zone de surface, en particulier dans des zones de gorges de segments de piston (104, 110), sur le fond de piston (109) et/ou sur la tige de piston (111), qui est réalisée sous forme de couche à base d'oxyde de chrome ou d'oxyde de chrome et d'alumine.
